# EUROPEAN PATENT SPECIFICATION

(11) **EP 1 774 404 B1**
(45) Date of publication and mention of the grant of the patent: **17.09.2008**
(21) Application number: 05774698.4
(22) Date of filing: 14.07.2005
(51) Int. Cl.: G03F 7/075

(54) **LITHOGRAPHIC PRINTING PLATES WITH HIGH PRINT RUN STABILITY**
LITHOGRAPHISCHE DRUCKPLATTEN MIT HOHER AUFLAGENSTABILITÄT
PLAQUES D'IMPRESSION LITHOGRAPHIQUE A GRANDE STABILITE D'IMPRESSION

(30) Priority: 16.07.2004 DE 102004034362
(43) Date of publication of application: 18.04.2007
(73) Proprietor: Kodak Graphic Communications GmbH, 37520 Osterode/Harz (DE)
(72) Inventor: TIMPE, Hans-Joachim, 37520 Osterode (DE); MÜLLER, Ursula, 37412 Herzberg (DE)
(74) Representative: Vossius & Partner
(86) International application number: PCT/EP2005/007686
(87) International publication number: WO 2006/008073

(56) References cited:
- EP-A1- 0 255 303
- EP-A1- 0 510 646
- EP-A2- 0 448 285
- EP-A2- 0 480 388
- JP-A- 3 028 852
- JP-A- 63 279 245

## Description

The present invention relates to radiation-sensitive elements having a coating comprising at least one silsesquioxane. The invention furthermore relates to radiation-sensitive compositions used for the production of said elements, a process for imaging such elements and imaged elements obtained therefrom.

The technical field of lithographic printing is based on the immiscibility of oil and water, wherein the oily material or the printing ink is preferably accepted by the image area, and the water or fountain solution is preferably accepted by the non-image area. When an appropriately produced surface is moistened with water and a printing ink is applied, the background or non-image area accepts the water and repels the printing ink, while the image area accepts the printing ink and repels the water. The printing ink in the image area is then transferred to the surface of a material such as paper, fabric and the like, on which the image is to be formed. Generally, however, the printing ink is first transferred to an intermediate material, referred to as blanket, which then in turn transfers the printing ink onto the surface of the material on which the image is to be formed; this technique is referred to as offset lithography.

A frequently used type of lithographic printing plate precursor comprises a photosensitive coating applied onto a substrate on aluminum basis. The coating can react to electromagnetic radiation such that the exposed portion becomes so soluble that it is removed during the developing process. Such a plate is referred to as positive working. On the other hand, a plate is referred to as negative working if the exposed portion of the coating is hardened by the radiation. In both cases, the remaining image area accepts printing ink, or is oleophilic, and the non-image area (background) accepts water, or is hydrophilic. The differentiation between image and non-image areas takes place during exposure, for which a film is attached to the printing plate precursor under vacuum in order to guarantee good contact. The plate is then exposed by means of a radiation source. Alternatively, the plate can also be exposed digitally without a film, e.g. with a UV laser. When a positive plate is used, the area on the film corresponding to the image on the plate is so opaque that the light does not reach the plate, while the area on the film corresponding to the non-image area is clear and allows light to permeate the coating, whose solubility increases. In the case of a negative plate, the opposite takes place: The area on the film corresponding to the image on the plate is clear, while the non-image area is opaque. The coating beneath the clear film area is hardened due to the incident light, while the area not affected by the light is removed during developing. The light-hardened surface of a negative working plate is therefore oleophilic and accepts printing ink, while the non-image area that used to be coated with the coating removed by the developer is desensitized and therefore hydrophilic.

It is known for example from DE 10 113 926 A1, DE 19 739 953 A1 and EP-B-0 900 653 that the use of inorganic particles or polymer particles, such as e.g. SiO₂ or polyethylene particles, in free-radical polymerizable radiation-sensitive coatings of printing plate precursors can improve the print run stability of a plate.

However, processing radiation-sensitive compositions comprising such particles is not very easy since the particles should be distributed as evenly as possible in the coating produced from the composition. Usually, this requires special dispersion processes as well as the use of dispersing agents. Still, an aggregation of the particles in the coating solution frequently occurs which is due to an insufficient storage stability of these solutions. Furthermore, the use of particles causes problems during the filtration of the coating solutions since the pore size of the filter has to be larger than the size of the particles used in the solution. However, insufficiently filtered coating solutions lead to coating imperfections.

Another possibility is the production of coatings containing inorganic particles or polymer particles using the so-called dual feed process (see e.g. US 6,548,215). However, this requires special coating techniques which increases the costs of the coating process.

However, in all cases, the particles present in the coating can easily break out of the coating during printing which then leads to a printed image of unacceptable low quality.

It is therefore the object of the present invention to provide a radiation-sensitive elements which, when used in the production of lithographic printing plates, allows a higher print run of the printing plates with - at the same time- a high degree of radiation sensitivity; furthermore, special dispersion processes should be avoided and break-outs in the image elements during printing should be largely excluded.

This object is achieved by a radiation-sensitive element comprising
(a) an optionally pretreated substrate and
(b) a radiation-sensitive coating consisting of a composition comprising
   (i) one or more types of monomers, each comprising at least one ethylenically unsaturated group accessible to a free-radical polymerization,
   (ii) at least one radiation-sensitive initiator or initiator system for free-radical polymerization absorbing radiation selected from the wavelength range of 300 to 1,200 nm; and
   (iii) at least one silsesquioxane comprising at least one substituent with at least one ethylenically unsaturated group each;
applied on a substrate.

The first essential component of the radiation-sensitive composition of the present invention is a monomer, oligomer and/or polymer with at least one ethylenically unsaturated group accessible to free-radical polymerization.

All monomers, oligomers and polymers which are free-radical polymerizable and comprise at least one C-C double bond can be used as ethylenically unsaturated monomers, oligomers and polymers. Monomers, oligomers and polymers with C-C triple bonds can also be used, but they are not preferred. Suitable compounds are well known to the person skilled in the art and can be used in the present invention without any particular limitations. Esters of acrylic and methacrylic acids, itaconic acid, crotonic acid, isocrotonic acid, maleic acid and fumaric acid with one or more unsaturated groups in the form of monomers, oligomers or prepolymers are preferred. They may be present in solid or liquid form, with solid and highly viscous forms being preferred. Compounds suitable as monomers include for instance trimethylol propane triacrylate and -methacrylate, pentaerythritol triacrylate and -methacrylate, dipentaerythritolmonohydroxy pentaacrylate and -methacrylate, dipentaerythritol hexaacrylate and -methacrylate, pentaerythritol tetraacrylate and -methacrylate, ditrimethylol propane tetraacrylate and -methacrylate, diethyleneglycol diacrylate and -methacrylate, triethyleneglycol diacrylate and -methacrylate or tetraethyleneglycol diacrylate and -methacrylate. Suitable oligomers and/or prepolymers are for example urethane acrylates and -methacrylates, epoxide acrylates and methacrylates, polyester acrylates and methacrylates, polyether acrylates and methacrylates or unsaturated polyester resins.

In addition to monomers and/or oligomers, use can also be made of polymers comprising free-radical polymerizable C-C double bonds in the main or side chains. Examples thereof include reaction products of maleic acid anhydride/olefin copolymers and hydroxyalkyl(meth)acrylates (cf. e.g. DE-A-4311738); (meth)acrylic acid polymers, partially or fully esterified with allyl alcohol (cf. e.g. DE-A-3332640); reaction products of polymeric polyalcohols and isocyanato(meth)acrylates; unsaturated polyesters; (meth)acrylate-terminated polystyrenes, poly(meth)acrylic acid ester, poly(meth)acrylic acids, poly(meth)acrylamides; (meth)acrylic acid polymers, partially or fully esterified with epoxides comprising free-radical polymerizable groups; and polyethers. In this connection, the prefix "(meth)" indicates that both derivatives of acrylic acid and of methacrylic acid can be used.

Additional suitable C-C-unsaturated free-radical polymerizable compounds are described e.g. in EP-A-1 176 007.

It is of course possible to use different kinds of monomers, oligomers or polymers in admixture; furthermore, mixtures of monomers and oligomers and/or polymers can be used in the present invention, as well as mixtures of oligomers and polymers. The free-radical polymerizable monomers/oligomers/polymers are preferably present in an amount of 5 to 95 wt.-%; if monomers/oligomers are used, especially preferred 20 to 85 wt.-%, based on the dry layer weight of a radiation-sensitive coating prepared from the radiation-sensitive composition of the present invention. As used in the present invention, the term "dry layer weight of the radiation-sensitive coating" is therefore synonymous with the term "solids of the radiation-sensitive composition".

Another essential component of the radiation-sensitive composition of the present invention is at least one radiation-sensitive initiator or an initiator system for free-radical polymerization of the monomers, oligomers or polymers present. It depends on the type of initiator or initiator system whether the radiation-sensitive element of the present invention is imaged with UV radiation, visible (VIS) radiation or IR radiation.

Initiators which directly form free radicals upon absorption of UV radiation are known to the person skilled in the art and are for example described in K.K. Dietliker: "Chemistry & Technology of UV&EB formulation for coatings, inks & prints", Vol. 3 (SITA Technology, London (1991)). They include for example oxime ethers and oxime esters, benzoins and benzoin ethers, α-hydroxy or α-aminoacetophenones, acyl phosphine oxides and diacyl phosphine oxides.

Within the framework of the present invention, an initiator system comprising
(a) a sensitizer which absorbs UV, VIS or IR radiation but is unable to form free radicals by itself, and
(b) a coinitiator which by itself, depending on which electromagnetic radiation is used for image-wise exposure, is unable to absorb the UV, VIS or IR radiation emitted from the radiation source, but together with the radiation-absorbing sensitizer used in the present invention forms free radicals
is especially preferred.

For the purpose of the present invention, these initiator systems are divided into two groups, namely those wherein the sensitizer absorbs radiation from the range of more than 750 to 1,200 nm (also briefly referred to as IR absorbers) and those wherein the sensitizer absorbs radiation from the range of 300 to 750 nm. When an initiator system of the first group is used, an IR-sensitive element is obtained whereas the use of an initiator system of the second group leads to a UV or VIS-sensitive element.

Based on its absorption properties, the sensitizer used in the initiator systems determines whether the radiation-sensitive composition is sensitive in the UV, VIS or IR range.

In the present invention, the IR absorbers are preferably selected from the class of triarylamine dyes, thiazolium dyes, indolium dyes, oxazolium dyes, cyanine dyes, polyaniline dyes, polypyrrol dyes, polythiophene dyes and phthalocyanine dyes and pigments. However, other IR absorbers, for example those described in EP 1 160 095 A1, can be used as well.

The following compounds are e.g. suitable IR absorbers:

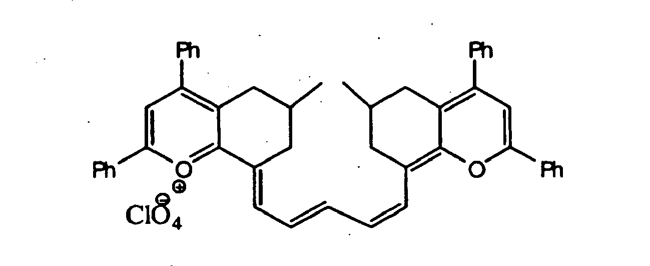

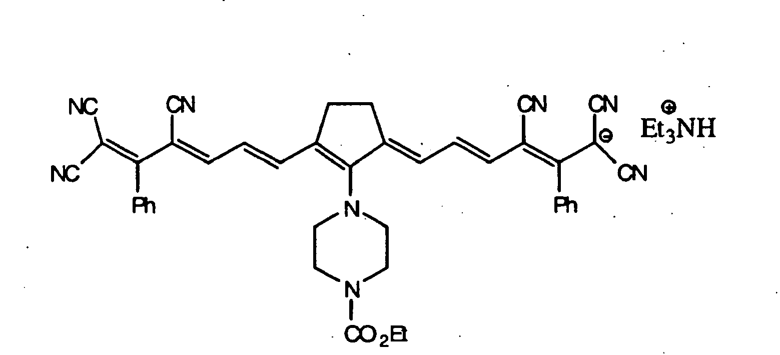

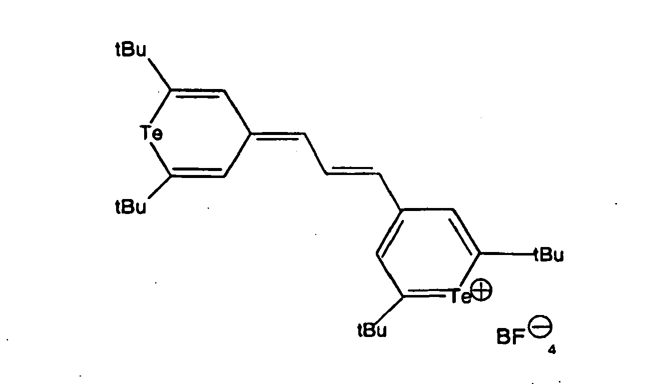

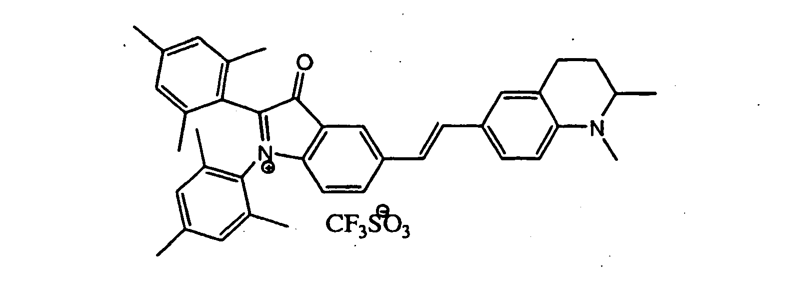

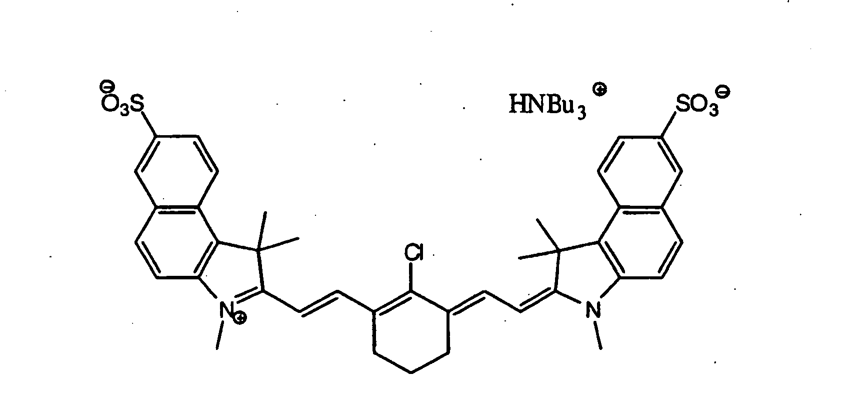

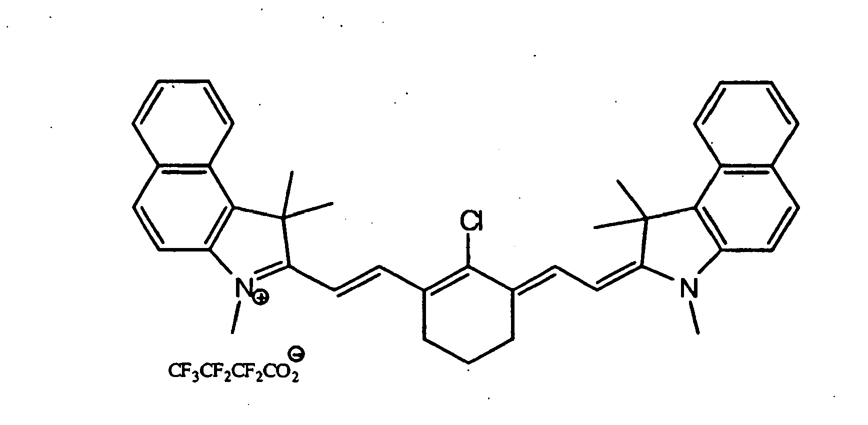

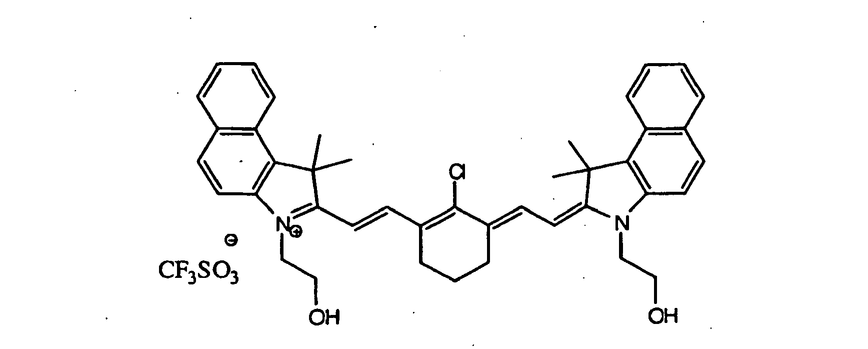

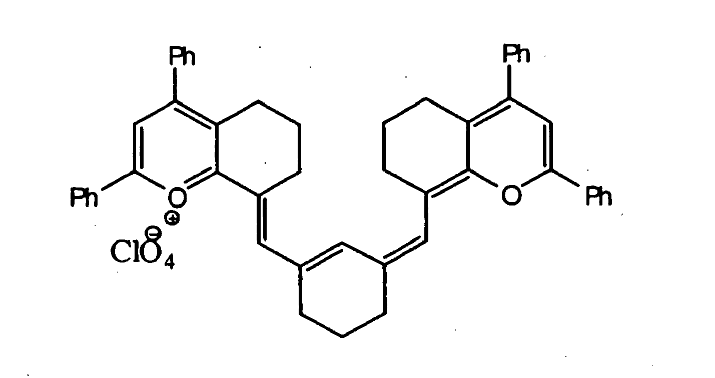

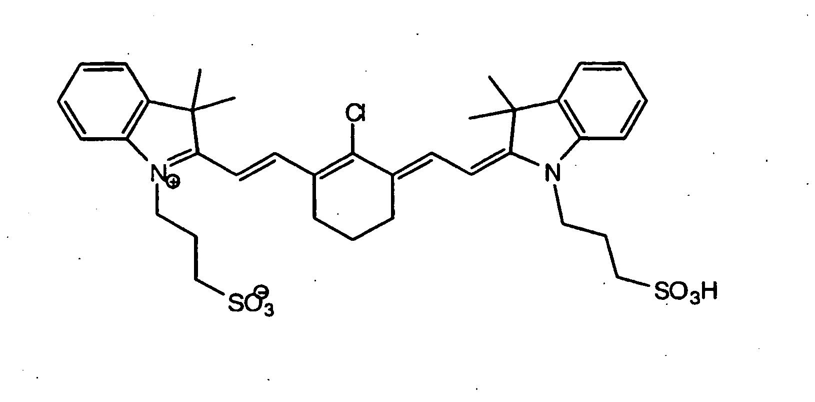

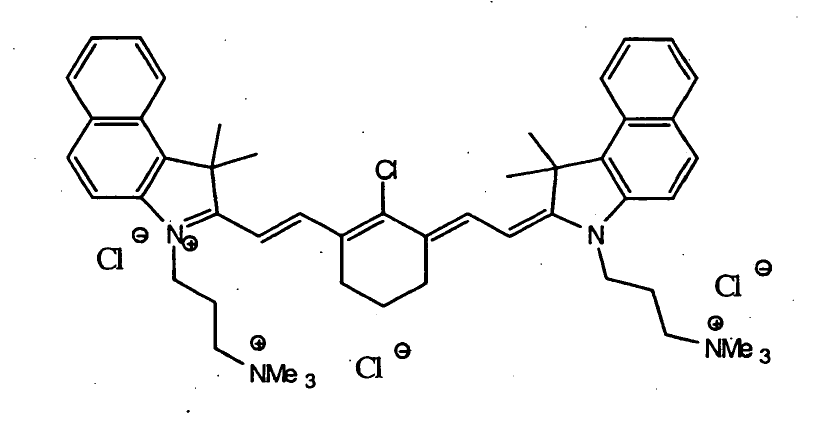

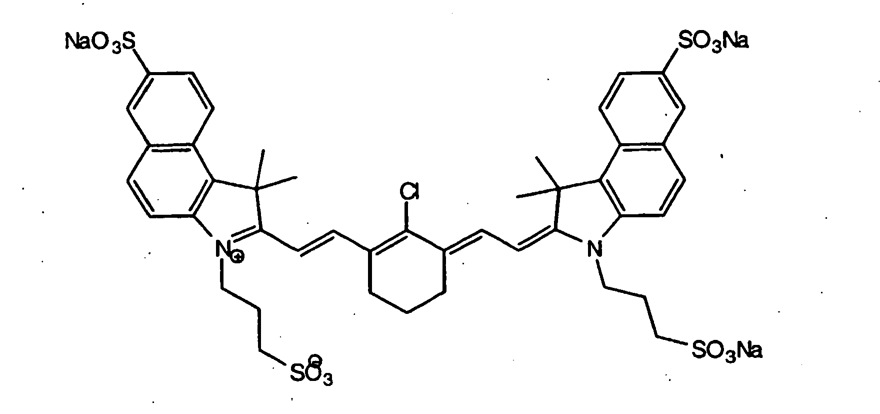

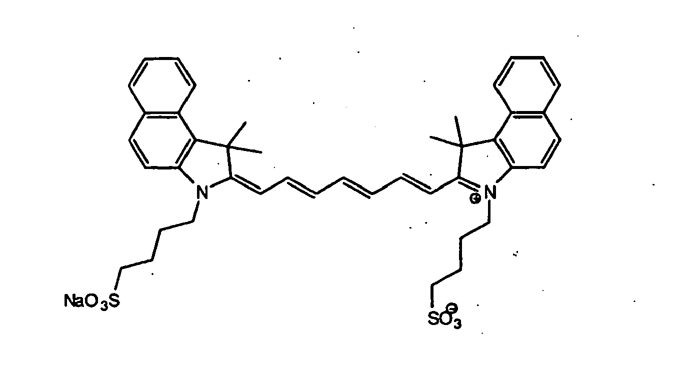

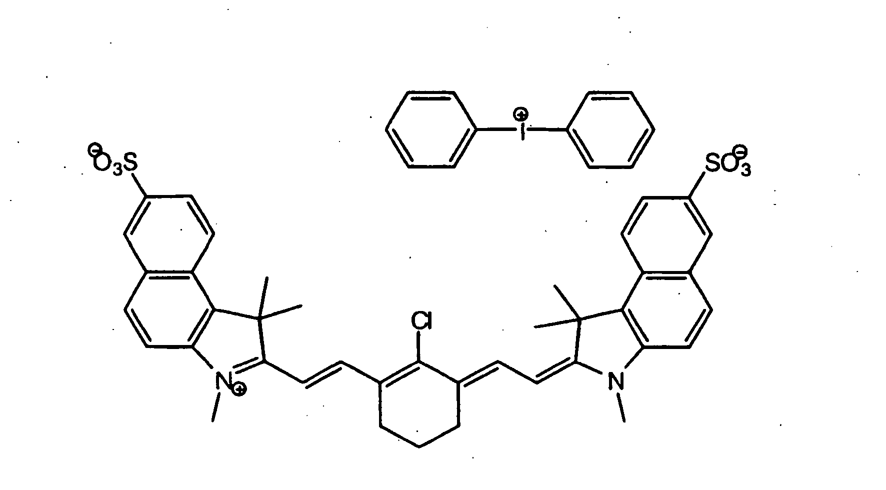

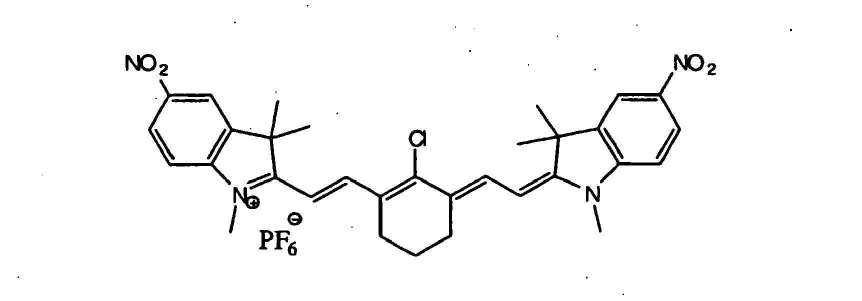

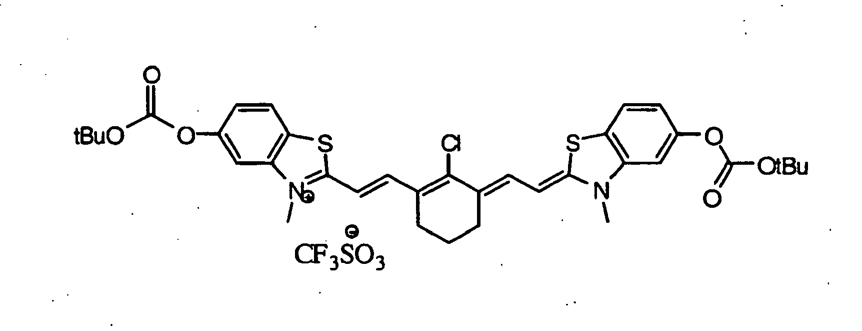

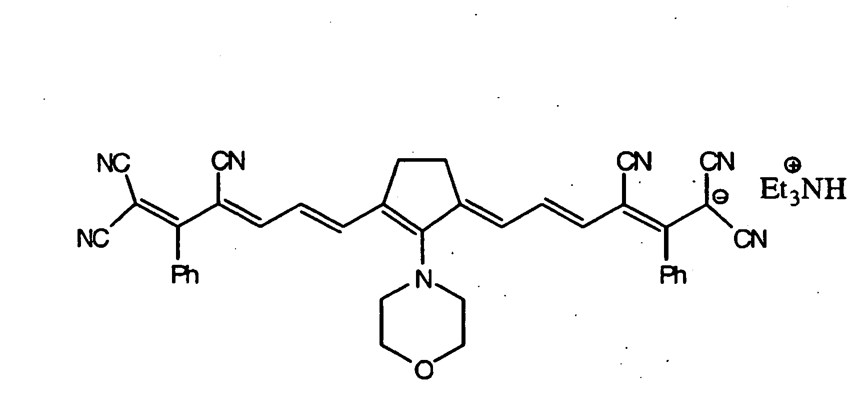

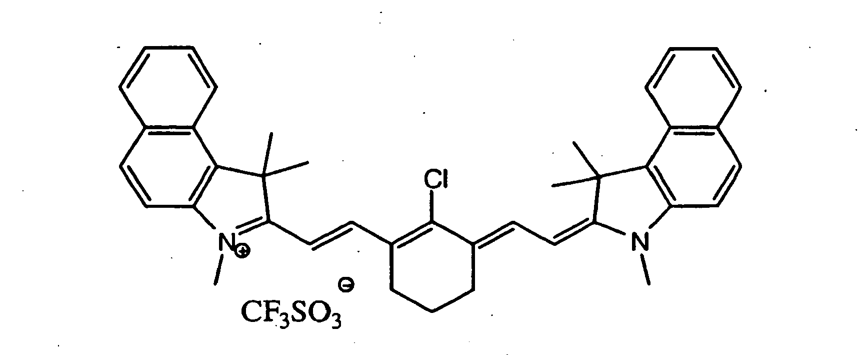

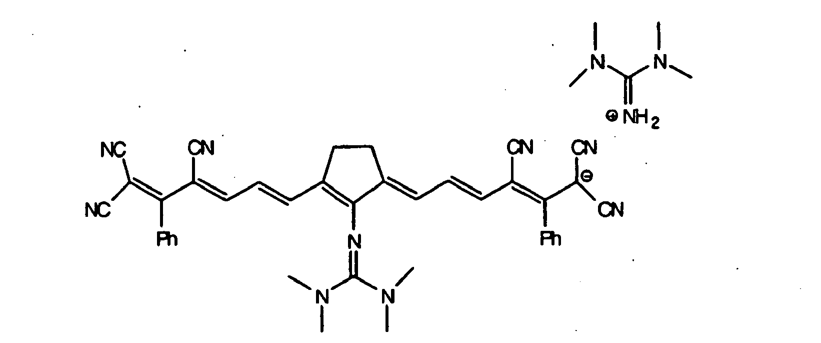

According to one embodiment of the present invention, an IR absorber of formula (I) is used. 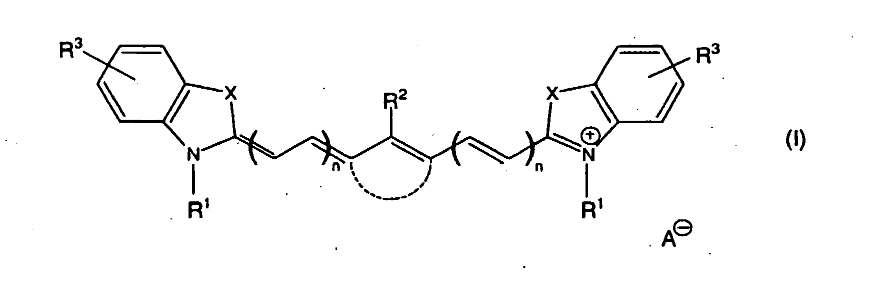 wherein
- each X: independently represents S, O, NR or C(alkyl)₂;
- each R¹: independently represents an alkyl group;
- R²: represents a halogen atom, SR, OR or NR₂;
- each R³: independently represents a hydrogen atom, an alkyl group, OR, SR or NR₂ or a halogen atom; R³ can also be benzofused;
- A⁻: represents an anion;
- ---: represents an optionally present carbocyclic five- or six-membered ring;
- R: represents an alkyl or aryl group; in the case of NR₂, one R can also be H;
- each n: can independently be 0, 1, 2 or 3.

These IR absorbers absorb in the range of 800 to 1,200 nm; those of formula (I) absorbing in the range of 810 to 860 nm are preferred.

X is preferably a group C(alkyl)₂, wherein the alkyl group preferably comprises 1 to 3 carbon atoms.
R¹ is preferably an alkyl group with 1 to 4 carbon atoms.
R² is preferably SR.
R³ is preferably a hydrogen atom.
R is preferably a phenyl group.
It is preferred that the dotted line represent the residue of a ring with 5 or 6 carbon atoms.
The counterion A⁻ is preferably a chloride ion or a tosylate anion.

IR absorbers with a symmetrical structure (I) are especially preferred.

Examples of especially preferred IR absorbers include:
2-[2-[2-Phenylsulfonyl-3-[2-(1,3-dihydro-1,3,3-trimethyl-2H-indole-2-ylidene)-ethylidene]-1-cyclohexene-1-yl]-ethenyl]-1,3,3-trimethyl-3H-indoliumchloride,
2-[2-[2-thiophenyl-3-[2-(1,3-dihydro-1,3,3-trimethyl-2H-indole-2-ylidene)-ethylidene]-1-cyclohexene-1-yl]-ethenyl]-1,3,3-trimethyl-3H-indoliumchloride,
2-[2-[2-thiophenyl-3-[2-(1,3-dihydro-1,3,3-trimethyl-2H-indole-2-ylidene)-ethylidene]-1-cyclopentene-1-yl]-ethenyl]-1,3,3-trimethyl-3H-indoliumtosylate,
2-[2-[2-chloro-3-[2-(1,3-dihydro-1,3,3-trimethyl-2H-benzo[e]-indole-2-ylidene)-ethylidene]-1-cyclohexene-1-yl]-ethenyl]-1,3,3-trimethyl-1H-benzo[e]-indolium-tosylate and
2-[2-[2-chloro-3-[2-ethyl-3H-benzthiazole-2-ylidene)-ethylidene]-1-cyclohexene-1-yl]-ethenyl]-3-ethyl-benzthiazolium-tosylate.
1,4-Dihydropyridines, oxazoles, bisoxazoles and analogues, coumarins, triarylmethane dyes and metallocenes can for example be used as UV or VIS-absorbing sensitizers. Such sensitizers are e.g. described in DE 42 17 495 A1, DE 44 18 645 C1, DE 2 801 065 C2, EP 1 041 074 A1 and DD 287 796 A.

In UV- or VIS-sensitive compositions, compounds of the formula (II) can be used as sensitizers of the oxazole type. 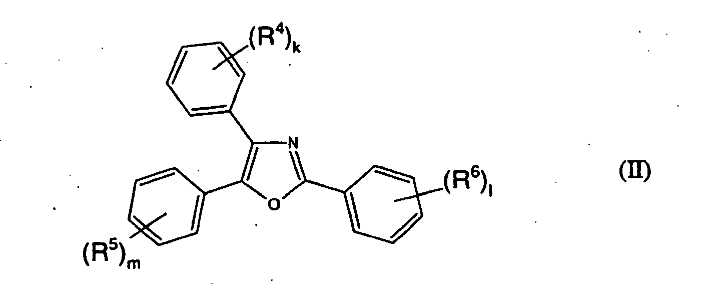 wherein each R⁴, R⁵ and R⁶ is independently selected from a halogen atom, an optionally substituted alkyl group, an optionally substituted aryl group, which may also be fused, an optionally substituted aralkyl group, a group -NR'R" and a group -OR"',
wherein R' and R" are independently selected from a hydrogen atom, an alkyl, aryl or aralkyl group,
R"' is an optionally substituted alkyl, aryl or aralkyl group or a hydrogen atom, and k, m and n are independently 0 or an integer from 1 to 5.

Preferably, R⁴, R⁵ and R⁶ are independently selected from a halogen atom, C₁-C₈ alkyl and a group -NR'R", wherein R' and R" are independently preferably selected from hydrogen atoms and C₁-C₆ alkyl.
k, l and m are independently preferably 0 or 1.
Oxazole derivatives of formula (II) wherein at least one of the groups R⁴, R⁵ and R⁶ represents a group -NR'R", wherein R' and R" are preferably independently selected from hydrogen atoms and C₁-C₆ alkyl, are especially preferred, and it is particularly preferred that R' = R" = C₁-C6 alkyl.

The oxazole derivatives of formula (II) mentioned above can be prepared according to processes well known to the person skilled in the art. In this connection, reference is made to DE-A-1120875 and EP-A-129 059; the processes described in these documents can also be used for the synthesis of oxazoles not explicitly described therein by varying the starting compounds accordingly.

Compounds of formula (III) can also be used as sensitizers for UV or VIS-sensitive compositions: 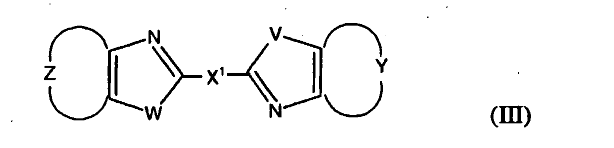 wherein X¹ is a spacer group comprising at least one C-C double bond conjugated to the heterocycles,
Y and Z independently represent an optionally substituted fused aromatic ring and
V and W are independently selected from O, S and NR⁷, wherein R⁷ is an alkyl, aryl or aralkyl group which can optionally be mono- or polysubstituted.

Preferably, V = W and represents O or NR⁷.

R⁷ is preferably C₁-C₁₂ alkyl.

The spacer group X¹ can be a chain-shaped or cyclic unit or a combination thereof. It is preferably selected from:

Phenylene, optionally comprising one or more benzofused aromatic rings (e.g. naphthylene), wherein the binding sites to the two heterocycles can be located at the same ring or at different rings, 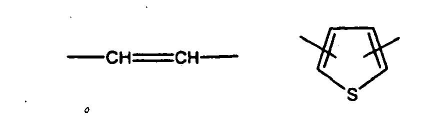 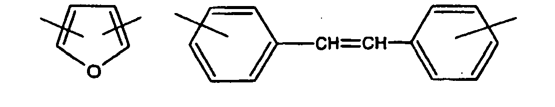 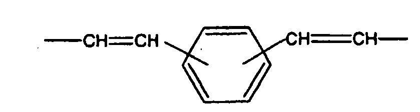 and

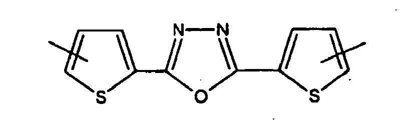

In the six-membered rings shown above, it is preferred that the binding sites be in the 1,4-position, in the five-membered rings, the 2,5-position is preferred. The five- and six-membered rings shown above can optionally comprise one or more substituents such as e.g. C₁-C₁₀ alkyl and halogen atoms, even if they are not shown in the above formulas.

Preferred sensitizers are represented by formulas (IIIa), (IIIb) and (IIIc): 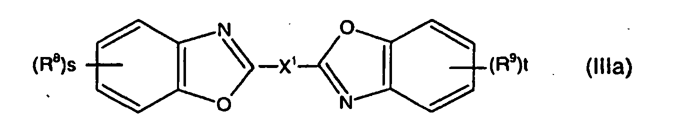 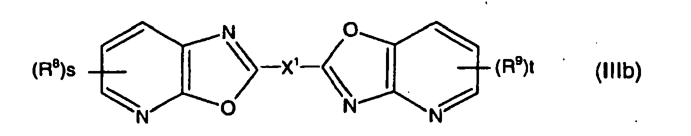 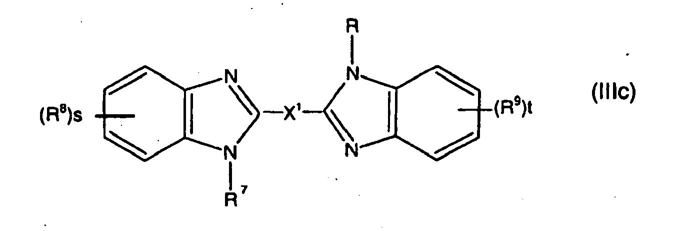 wherein s and t are independently 0 or an integer from 1 to 4 (preferably 0 or 1), each group R¹⁰ and R¹¹ is independently selected from a halogen atom, an alkyl, aryl, aralkyl, alkoxy, aryloxy, aralkyloxy group, a saturated or non-aromatic unsaturated carbocyclic ring, a fused aryl group, -SO₃H, -NR¹⁰₂, -COOR¹¹ and -COR¹¹,
each group R¹⁰ is independently a hydrogen atom or an alkyl group and each group R¹¹ is independently selected from a hydrogen atom, an alkyl and an aryl group, and
X¹ and R⁷ are as defined above.

R⁸ and R⁹ are preferably independently selected from -NR¹⁰₂, an alkoxy group and an alkyl group.

R¹⁰ is preferably C₁-C₁₀ alkyl.

R¹¹ is preferably C₁-C₁₀ alkyl.

Y and Z preferably represent benzofused aromatic rings which may optionally be substituted.

The sensitizers of formula (III) can be prepared according to processes well known to the person skilled in the art. In this connection, reference is made to A. Dorlars et al., Angew. Chemie [Applied Chemistry], Vol. 87 (1975), 693-707; the processes described therein can also be used for the synthesis of compounds not explicitly disclosed therein by varying the starting compounds accordingly.

Other possible sensitizers for UV- or VIS-sensitive compositions include 1,4-dihydropyridine compounds of formula (IV) 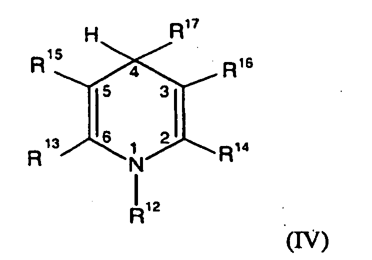 wherein
R¹² is selected from a hydrogen atom, -C(O)OR¹⁸, an optionally substituted alkyl group, an optionally substituted aryl group and an optionally substituted aralkyl group,
R¹³ and R¹⁴ are independently selected from optionally substituted alkyl groups, optionally substituted aryl groups, CN and a hydrogen atom,
R¹⁵ and R¹⁶ are independently selected from -C(O)OR¹⁸, -C(O)R¹⁸, -C(O)NR¹⁹R²⁰ and CN,
or R¹³ and R¹⁵ together form an optionally substituted phenyl ring or a 5- to 7-membered carbocyclic or heterocyclic ring, wherein the unit 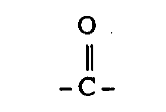 is present in the carbocyclic or heterocyclic ring adjacent to position 5 of the dihydropyridine ring and wherein the carbocyclic or heterocyclic ring optionally comprises additional substituents,
or both R¹³ and R¹⁵ as well as R¹⁴ and R¹⁶ form either optionally substituted phenyl rings or 5-to 7-membered carbocyclic or heterocyclic rings, wherein the unit 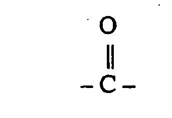 is present in the carbocyclic or heterocyclic rings adjacent to positions 3 and 5 of the dihydropyridine ring and wherein the carbocyclic or heterocyclic rings optionally comprise additional substituents,
or one of the pairs R¹³/R¹⁵ and R¹⁴/R¹⁶ forms a 5- to 7-membered carbocyclic or heterocyclic ring, wherein the unit 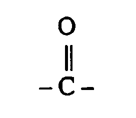 is present in the carbocyclic or heterocyclic ring adjacent to position 5 or 3 of the dihydropyridine ring and wherein the carbocyclic or heterocyclic ring optionally comprises additional substituents and the other pair forms an optionally substituted phenyl ring,
or R¹³ and R¹² or R¹⁴ and R¹² form a 5- to 7-membered heterocyclic ring which can optionally comprise one or more substituents and which, in addition to the nitrogen atom it shares with the 1,4-dihydropyridine ring, optionally comprises additional nitrogen atoms, -NR' groups, -S- or -O-,
R' is selected from a hydrogen atom, an alkyl group, aryl group and aralkyl group,
R¹⁷ is selected from an alkyl group optionally substituted with a halogen atom or a -C(O) group, an optionally substituted aryl group, an optionally substituted aralkyl group, an optionally substituted heterocyclic group and the group 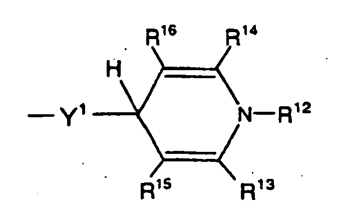 wherein Y¹ is an alkylene or arylene group,
R¹⁸ is a hydrogen atom, aryl group, aralkyl group or alkyl group, wherein the alkyl group and the alkyl unit of the aralkyl group optionally comprise one or more C-C double and/or C-C triple bonds,
and R¹⁹ and R²⁰ are independently selected from a hydrogen atom, an optionally substituted alkyl group, an optionally substituted aryl group and an optionally substituted aralkyl group.

According to a preferred embodiment, R¹² is a hydrogen atom.

If R¹³ and R¹⁴ do not form rings with adjacent substituents, they are preferably independently selected from C₁-C₅ alkyl groups or aryl groups.

If R¹⁵ and R¹⁶ do not form rings with adjacent substituents, they are preferably independently selected from -C(O)OR¹⁸.

R¹⁷ is preferably selected from C₁-C₅ alkyl groups or aryl groups.

R¹⁸ is preferably selected from C₁-C₅ alkyl groups and it is especially preferred that it represents a methyl group.

According to one embodiment, the substitution of the 1,4-dihydropyridine ring with R¹³/R¹⁵ and R¹⁴/R¹⁶ is symmetrical, i.e. R¹³ = R¹⁴ and R¹⁵ = R¹⁶.

According to a preferred embodiment, R¹³ and R¹⁴ are independently selected from optionally substituted alkyl groups, optionally substituted aryl groups, CN and a hydrogen atom, and R¹⁵ and R¹⁶ are independently selected from -C(O)OR¹⁸, -C(O)R¹⁸, -C(O)NR¹⁹R²⁰ and CN.

Further suitable sensitizers are 1,4-dihydropyridine derivatives of formula (IVa) 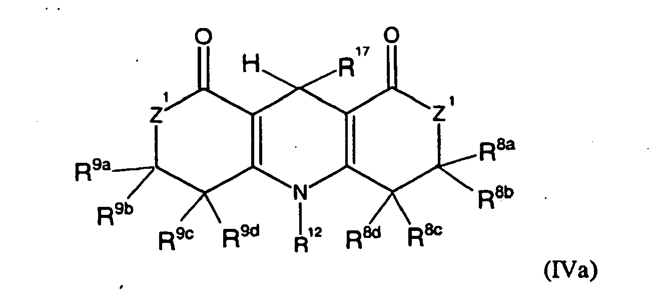 wherein R¹² and R¹⁷ are as defined above,
the groups R^{8a} to R^{8d} and R^{9a} to R^{9d} are independently selected from a hydrogen atom, alkyl groups and aryl groups, wherein two groups R⁹ and/or R⁸ of adjacent ring carbon atoms can also form a saturated or unsaturated carbocyclic or heterocyclic ring or fused aromatic ring together,
each Z¹ is independently selected from CR'₂, O, S and NR' and
each R' independently represents a hydrogen atom, alkyl, aralkyl or aryl group,
of formula (IVb) 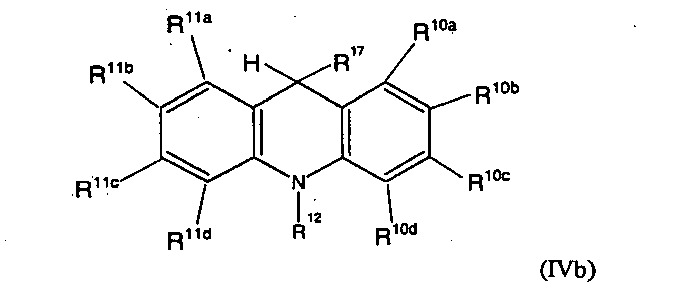 wherein R¹² and R¹⁷ are as defined above, and
R^{10a} to R^{10d} and R^{11a} to R^{11d} are independently selected from a hydrogen atom, alkyl groups, aryl groups, aralkyl groups, halogen atoms (fluorine, chlorine, bromine, iodine), CN, NR'₂, C(O)OR' and OR', (each R' independently represents a hydrogen atom, an alkyl group, aryl group or aralkyl group), wherein two groups R¹¹ and/or R¹⁰ of adjacent ring carbon atoms can also form an unsaturated carbocyclic or heterocyclic ring or fused aromatic ring together,
of formula (IVc) 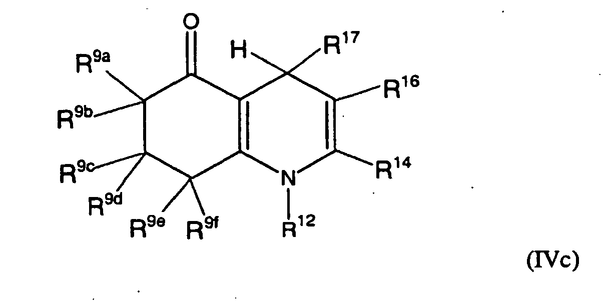 wherein R¹², R¹⁴, R¹⁶ and R¹⁷ are as defined above and the groups R^{9a} to R^{9f} are independently selected from a hydrogen atom, alkyl groups, aryl groups, aralkyl groups, halogen atoms (fluorine, chlorine, bromine, iodine), CN, NR'₂, C(O)OR' and OR', (R' independently represents a hydrogen atom, an alkyl group, aryl group or aralkyl group), wherein two groups R⁹ of adjacent ring carbon atoms can also form a saturated or unsaturated carbocyclic or heterocyclic ring or fused aromatic ring together,
of formula (IVd) 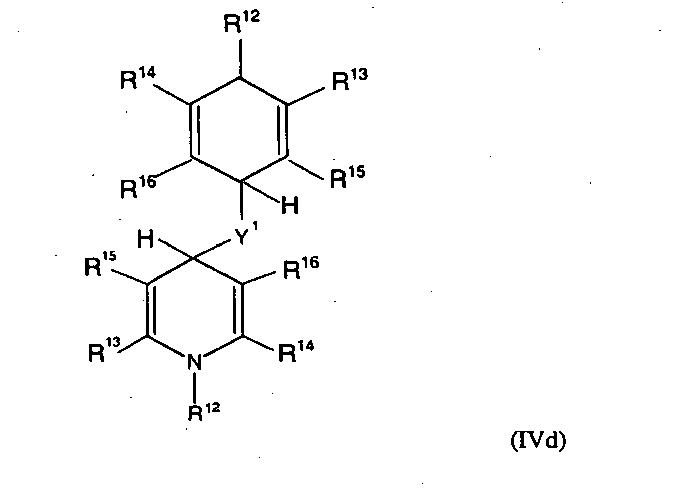 wherein each R¹², R¹³, R¹⁴, R¹⁵ and R¹⁶ independently is as defined above and Y¹ is selected from alkylene and arylene,
of formula (IVe) 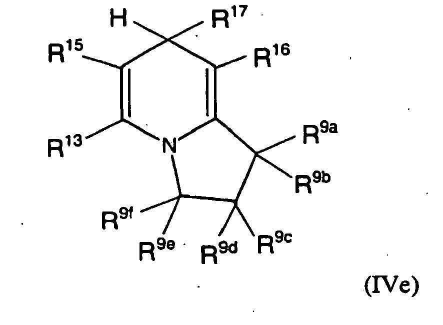 wherein R¹³, R¹⁵, R¹⁶ and R¹⁷ are as defined above and the groups R^{9a} to R^{9f} are defined as are groups R^{9a} to R^{9d} of formula (IVa),
of formula (IVf) 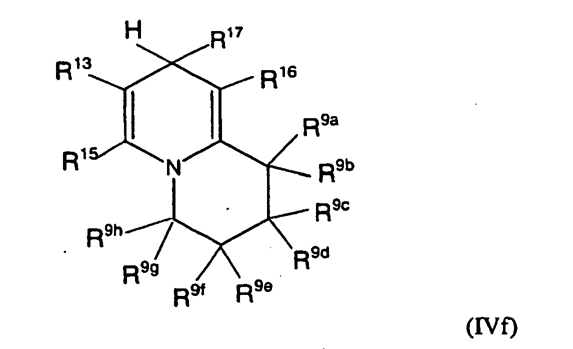 wherein R¹³, R¹⁵, R¹⁶ and R¹⁷ are as defined above and the groups R^{9a} to R^{9h} are defined as are groups R^{9a} to R^{9d} of formula (IVa)
and of formula (IVg) 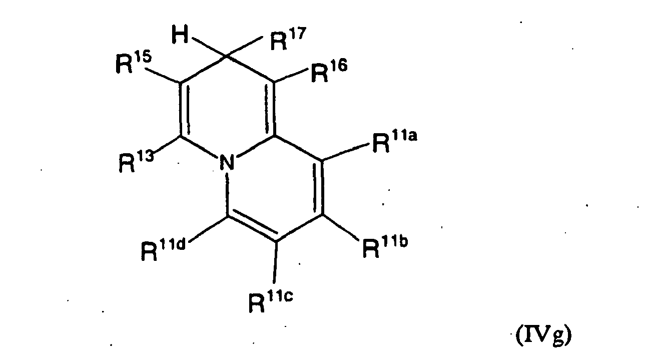 wherein R¹³, R¹⁵, R¹⁶ and R¹⁷ are as defined above and the groups R^{11a} to R^{11d} are independently selected from a hydrogen atom, alkyl groups, aryl groups, aralkyl groups, halogen atoms (fluorine, chlorine, bromine, iodine), CN, NR'₂, COOR' and OR' (R' independently represents a hydrogen atom, an alkyl group, aryl group or aralkyl group), wherein two adjacent groups R¹¹ of adjacent ring carbon atoms can also form an unsaturated carbocyclic or heterocyclic ring or fused aromatic ring together.

It goes without saying that the number of groups R⁸ and/or R⁹ in formulas (IVa), (IVc), (IVe) and (IVf) is reduced if two groups R⁸ and/or R⁹ of adjacent ring carbon atoms together form a fused aromatic ring.

In the 1,4-dihydropyridine derivatives of formula (IVa), R¹² is preferably a hydrogen atom, R¹⁷ is a methyl or phenyl group and Z¹ is preferably O or CH₂; the substituents R^{8a} to R^{8d} and R^{9a} to R^{9d} are independently preferably selected from hydrogen atoms and methyl groups. Of the derivatives of formula (IVa) those with symmetrical substitution at the dihydropyridine ring are especially preferred.

In the derivatives of formula (IVb), R¹² is preferably a hydrogen atom and R¹⁷ is preferably a methyl or phenyl group. The substituents R^{10a} to R^{10d} and R^{11a} to R^{11d} are independently preferably selected from C₁-C₅ alkyl groups, OR' and halogen atoms; a symmetrical substitution of the two aromatic rings is especially preferred.

In the 1,4-dihydropyridine derivatives of formula (IVc), R¹² is preferably a hydrogen atom, R¹⁷ is preferably a methyl or phenyl group, R¹⁴ is preferably a methyl group and R¹⁶ is preferably C(O)OR¹⁸ (wherein R¹⁸ is as defined above). The substituents R^{9a} to R^{9f} are independently preferably selected from C₁-C₅ alkyl groups. A methyl group is especially preferred.

In the derivatives of formula (IVd), Y¹ is preferably a 1,4-phenylene or 1,2-ethylene group. Furthermore, it is preferred that both groups R¹² be the same, both groups R¹³ be the same, both groups R¹⁴ be the same, both groups R¹⁵ be the same and both groups R¹⁶ be the same; the preferred definitions given with respect to formula (IV) apply to all groups R¹² to R¹⁶

In the derivatives of formula (IVe), R¹³ is preferably C₁-C₅ alkyl, R¹⁵ is preferably -C(O)OR¹⁸, R¹⁶ is preferably C(O)OR¹⁸ and R¹⁷ is preferably C₁-C₅ alkyl or a phenyl group (R¹⁸ is as defined above). The substituents R^{9a} to R^{9f} are preferably independently selected from C₁-C₅ alkyl groups.

In the derivatives of formula (IVf), R¹³ is preferably C₁-C₅ alkyl, R¹⁵ is preferably C(O)OR¹⁸, R¹⁶ is preferably C(O)OR¹⁸ and R¹⁷ is preferably a C₁-C₅ alkyl or a phenyl group (wherein R¹⁸ is as defined above). The substituents R^{9a} to R^{9h} are preferably independently selected from C₁-C₅ alkyl groups.

In the derivatives of formula (IVg), R¹³ is preferably C₁-C₅ alkyl, R¹⁵ is preferably C(O)OR¹⁸, R¹⁶ is preferably C(O)OR¹⁸ and R¹⁷ is preferably a C₁-C₅ alkyl or a phenyl group. The substituents R¹¹ are preferably independently selected from C₁-C₅ alkyl groups.

Of the 1,4-dihydropyridine derivatives of formulas (IVa) to (IVg) those of formulas (IVa) and (IVd) are especially preferred.

The 1,4-dihydropyridine derivatives of formula (IV) can be prepared according to processes well known to the person skilled in the art, such as the Hantzsch synthesis. As an example, reference is made to J. Org. Chem. 30 (1965), p. 1914 et seqq., and Angew. Chem. [Applied Chemistry] (Intern.) 20 (1981), p. 762 et seqq.; the processes described therein can also be used for the synthesis of 1,4-dihydropyridines not explicitly disclosed therein by varying the starting compounds accordingly.

Compounds of formula (V) can also be used as sensitizers for UV- or VIS-sensitive compositions: 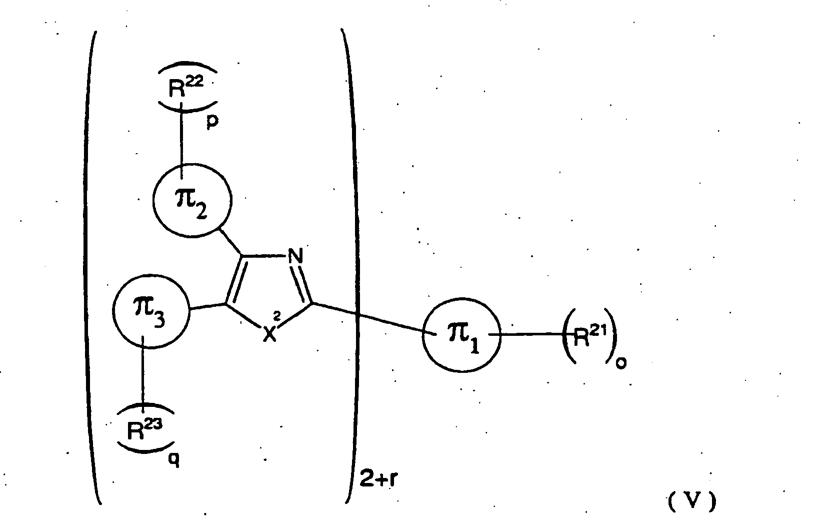 wherein
X² is selected from O, S and Se;
r represents 0 or a positive integer;
o, p and q are independently 0 or a positive integer;
the π-units 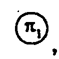 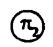 and 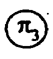 are independently unsaturated units, each with a conjugated π-electron system, which are covalently bonded to the heterocyclic unit 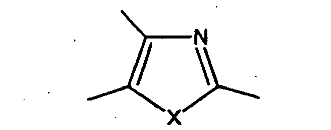 and together with this unit again form a conjugated π-electron system and
each group R²¹, R²² and R²³ is independently selected from a hydrogen atom, a halogen atom, an alkyl group, an aralkyl group, a group -NR²⁴R²⁵ and a group OR²⁶,
wherein R²⁴, R²⁵ and R²⁶ are independently selected from an alkyl group, aryl group and aralkyl group.

For the person skilled in the art, it goes without saying that due to the number of binding sites available at the π-units 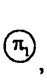 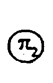 and 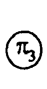 the maximum number of substituents R²¹, R²² and R²³ (i.e. o, p and q) is limited; the same of course applies to the maximum number (2+r) of the heterocyclic units bonded to

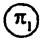

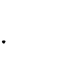

If X² = O, 2,4,5-substituted oxazoles are obtained,
accordingly, if X² = S, 2,4,5-substituted thiazoles are obtained and
accordingly, if X² = Se, 2,4,5-substituted selenazoles are obtained; of those compounds, oxazoles and thiazoles are preferred, and oxazoles are especially preferred.
r is preferably 0, 1 or 2, especially preferred 0 or 1.

The substituted heterocyclic unit 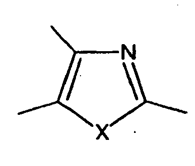 is bonded at least twice (r=0) to 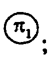 it is not necessary that these substituents of 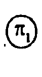 all be the same, i.e. for every substituent of 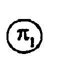 each X², 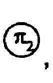 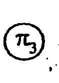 R²², R²³, p and q is selected independently:

The unsaturated unit 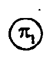 is preferably selected from:
a polyene group SUS-1 with alternating double bonds: 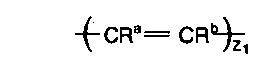 wherein z₁ is a positive integer (preferably 1 to 3, especially preferred 1 or 2), and R^{a} and R^{b} are independently selected from H, alkyl, aryl, halogen, -CN, -COOH and -COO-alkyl (preferably H, -CN and CH₃),
a polyyne group SUS-2 with alternating triple bonds: 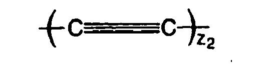 wherein z₂ is a positive integer (preferably 1 or 2, especially preferred 1),
a group SUS-3, which is a π-branched aromatic unit with (4n+2) π-electrons, preferably one of the structures SUS-3-a, SUS-3-b and SUS-3-c: 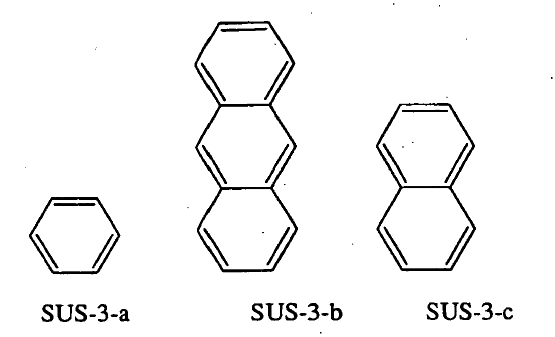 a group SUS-4, which is a π-branched electron-deficient heteroaromatic unit, preferably a group SUS-4-a, SUS-4-b, SUS-4-c, SUS-4-d and SUS-4-e 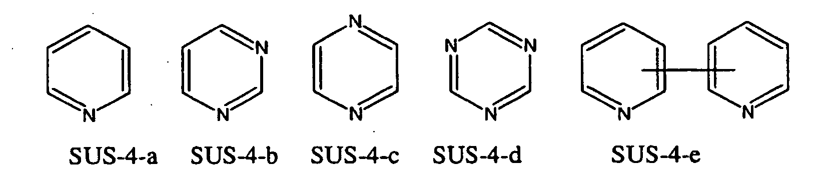 a group SUS-5, which is a π-branched electron-rich heteroaromatic unit, preferably a group SUS-5-a, SUS-5-b or SUS-5-c 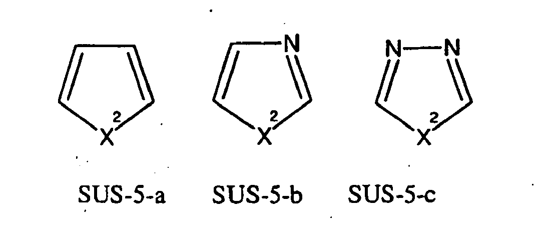 wherein X² is selected from O, S and Se and
a group SUS-6, which is a π-branched electron-rich heteroaromatic unit with two fused aromatic rings, 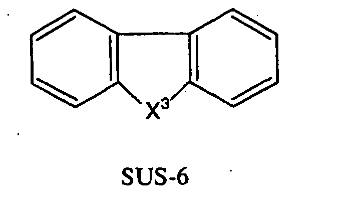 wherein X³ represents a heteroatom, preferably O, S, Se, NH or N-alkyl (wherein the alkyl group preferably comprises 1 to 5 carbon atoms), especially preferred O or S;
combinations of the above-mentioned groups SUS-1 to SUS-6 can also be used as unit 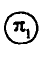 as long as the π-conjugation in the unit 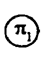 and the entire system (I) is maintained.

The optional substituents R²¹ are not shown in the groups SUS-1 to SUS-6. It is especially preferred that 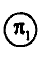 represents:

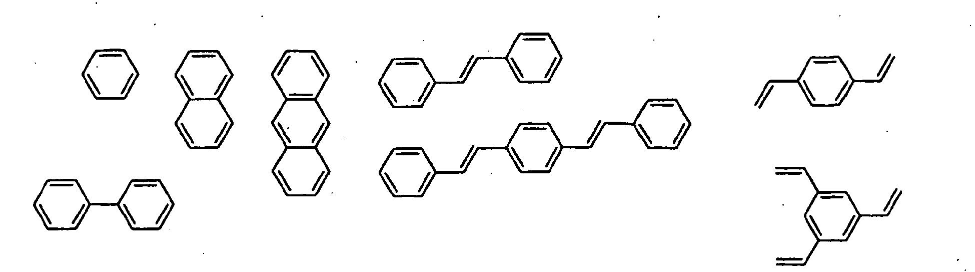

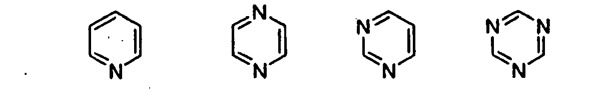

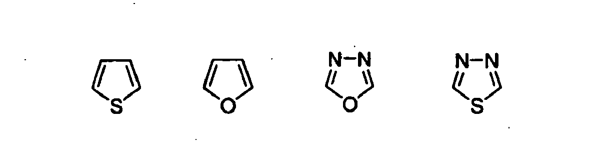

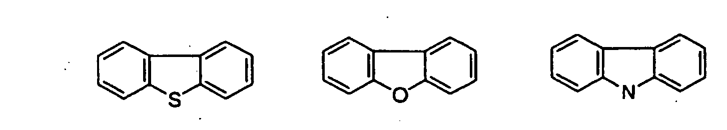

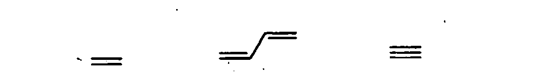

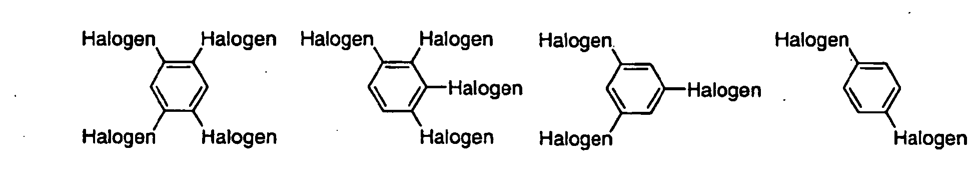

It is particularly preferred that 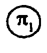 represents:

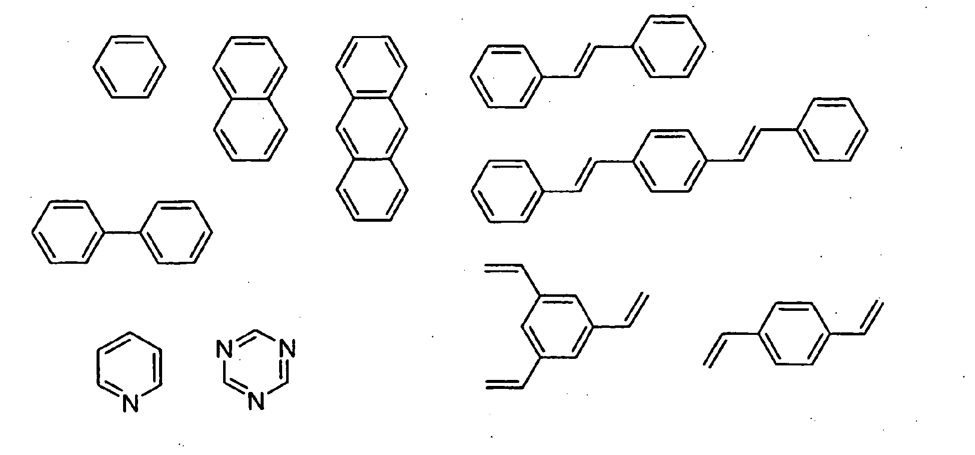

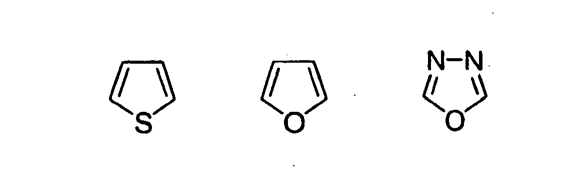

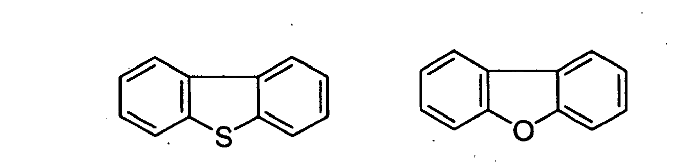

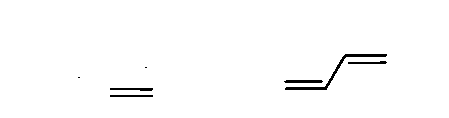

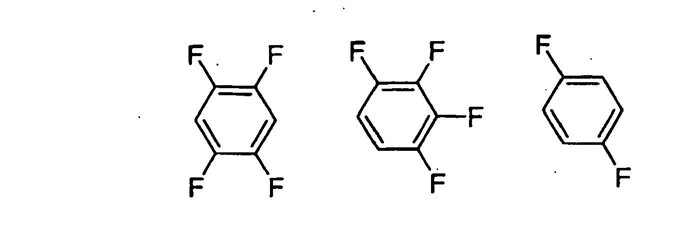

The units 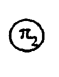 and 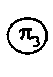 preferably also represent structures SUS-1 to SUS-6; the optional substituents R²² and R²³ are not shown. It is especially preferred that 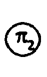 and 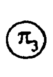 each represent optionally substituted aryl groups, in particular phenyl groups, which are optionally mono- or polysubstituted with a halogen atom or a group NR²⁷ (each R²⁷ is preferably independently selected from alkyl and aryl).

Compounds with a covalent bond between 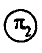 and 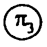 as depicted below 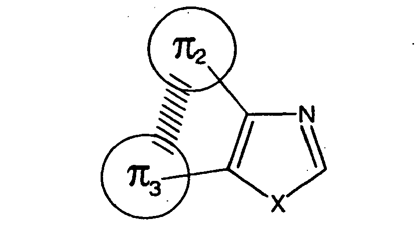 are not sensitizers according to the present invention; the interaction between 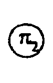 and 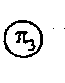 results in chromophores which do not lead to a highly sensitive photosystem.

The optional substituents R²¹, R²² and R²³ are independently selected from a hydrogen atom, a halogen atom, an alkyl group (preferably C₁-C₈), an aralkyl group, a group -NR²⁴R²⁵ (wherein R²⁴ and R²⁵ are independently selected from alkyl (preferably C₁-C₈), aryl and aralkyl) and a group -OR²⁶ (wherein R²⁶ is selected from alkyl (preferably C₁-C₈), aryl and aralkyl).

The following compounds of formula (V) are especially preferred:

### Sensitizer 1:

### 4-(5-(2-Chlorophenyl)-2-(4-(5-(2-chlorophenyl)-4-(4-(diethylamino)phenyl)oxazole-2-yl)phenyl)oxazole-4-yl)-N,N-diethylbenzeneamine

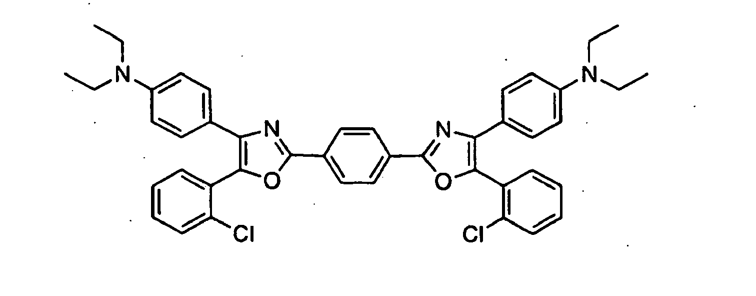

### Sensitizer 2:

### 4-(2-(4-(4-(4-(Dimethylamino)phenyl)-5-phenyloxazole-2-yl)phenyl)-5-phenyloxazole-4-yl)-N,N-dimethylbenzeneamine

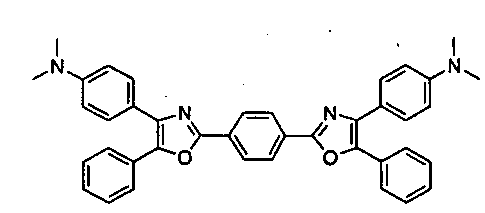

### Sensitizer 3:

### 4-(5-(2-Chlorophenyl)-2-(4-(5-(2-chlorophenyl)-4-(4-(diethylamino)phenyl)oxazole-2-yl)-2,3,5,6-tetrafluorophenyl)oxazole-4-yl)-N,N-diethylbenzeneamine

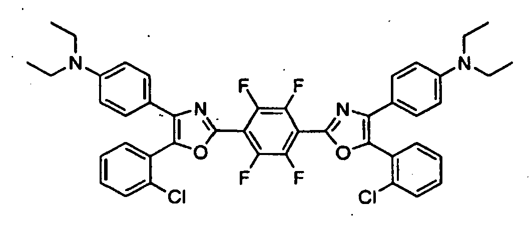

### Sensitizer 4:

### 4-(5-(2-Chlorophenyl)-2-(9-(5-(2-chlorophenyl)-4-(4-(diethylamino)phenyl)oxazole-2-yl)anthracene-10-yl)oxazole-4-yl)-N,N-diethylbenzeneamine

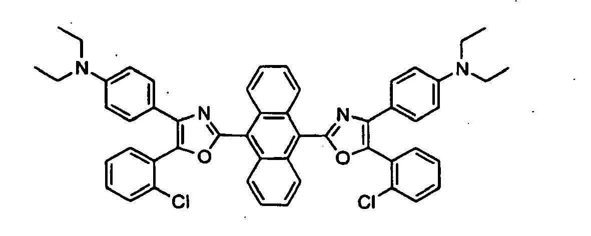

### Sensitizer 5:

### 4-(2-(2-((1E,13E)-4-((E)-2-(4-(4-(Dimethylamino)phenyl)-5-phenyloxazole-2-yl)styryl)styryl)phenyl)-5-phenyloxazole-4-yl)-N,N-dimethylbenzeneamine

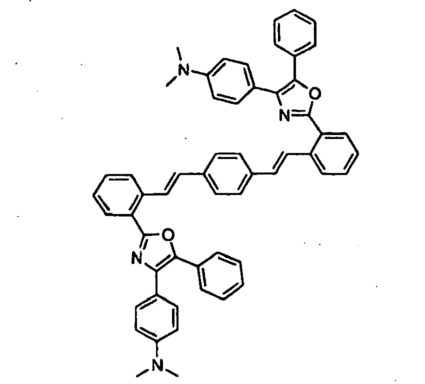

### Sensitizer 6:

### 4-(2-(4-((1E,13E)-4-((E)-2-(4-(4-(Dimethylamino)phenyl)-5-phenyloxazole-2-yl)styryl)styryl)phenyl)-5-phenyloxazole-4-yl)-N,N-dimethylbenzeneamine

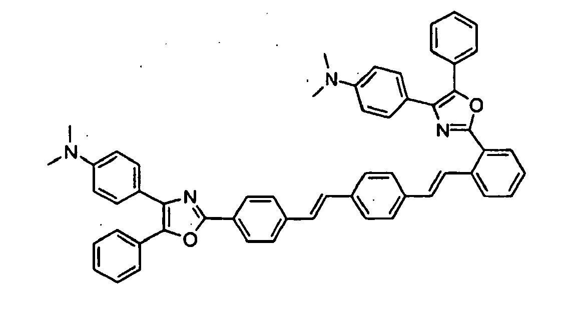

### Sensitizer 7:

### 4-(5-(2-Chlorophenyl)-2-(2-(5-(2-chlorophenyl)-4-(4-(diethylamino)phenyl)oxazole-2-yl)-3,4,5,6-tetrafluorophenyl)oxazole-4-yl)-N,N-diethylbenzeneamine

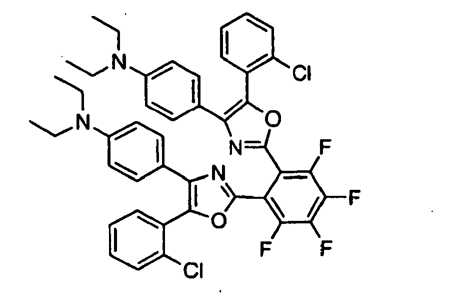

### Sensitizer 8:

### 4-(2-((1E,28E)-4-((E)-2-(4-(4-(Dimethylamino)phenyl)-5-phenyloxazole-2-yl)vinyl)styryl)-5-phenyloxazole-4-yl)-N,N-dimethylbenzeneamine

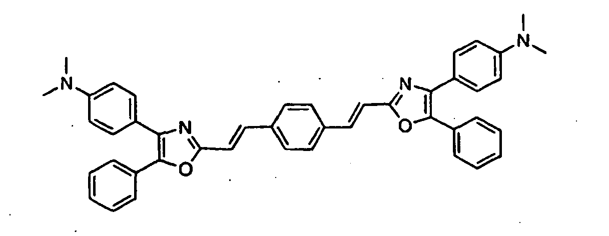

### Sensitizer 9:

### (E)-4-(2-(4-(4-(4-(4-(Dimethylamino)phenyl)-5-phenyloxazole-2-yl)styryl)phenyl)-5-phenyloxazole-4-yl)-N,N-dimethylbenzeneamine

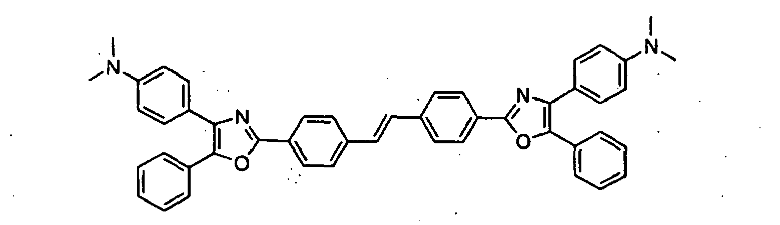

### Sensitizer 10:

### 4-(2-(4-((1E,26E)-4-((E)-4-(4-(4-(Dimethylamino)phenyl)-5-phenyloxazole-2-yl)styryl)styryl)phenyl)-5-phenyloxazole-4-yl)-N,N-dimethylbenzeneamine

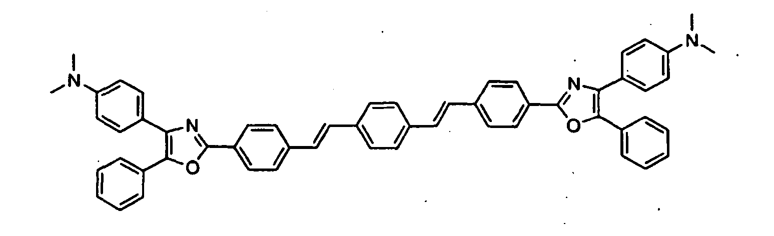

### Sensitizer 11:

### 4-(2-((E)-2-(5-((E)-2-(4-(4-(Dimethylamino)phenyl)-5-phenyloxazole-2-yl)vinyl)thiophene-2-yl)vinyl)-5-phenyloxazole-4-yl)-N,N-dimethylbenzeneamine

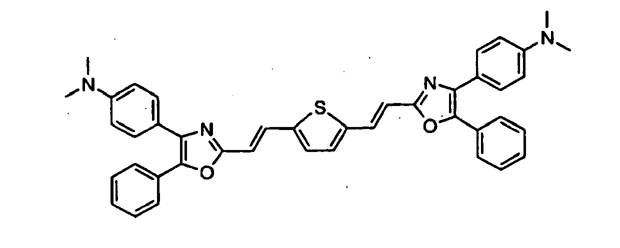

### Sensitizer 12:

### N-(4-(2-(4-(4-(4-(Diphenylamino)phenyl)-5-(perfluorophenyl)oxazole-2-yl)phenyl)-5-(perfluorophenyl)oxazole-4-yl)phenyl)-N-phenylbenzeneamine

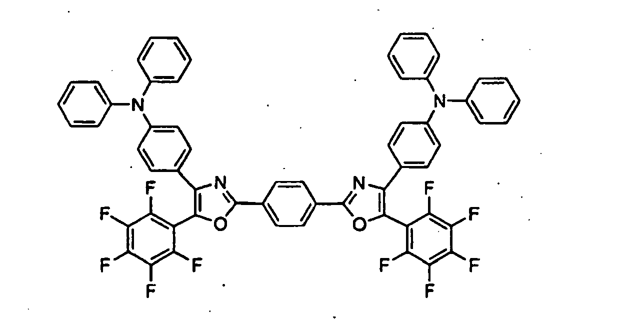

### Sensitizer 13:

### 4-(5-(2-Chlorophenyl)-2-(6-(5-(2-chlorophenyl)-4-(4-(diethylamino)phenyl)oxazole-2-yl)pyridine-2-yl)oxazole-4-yl)-N,N-diethylbenzeneamine

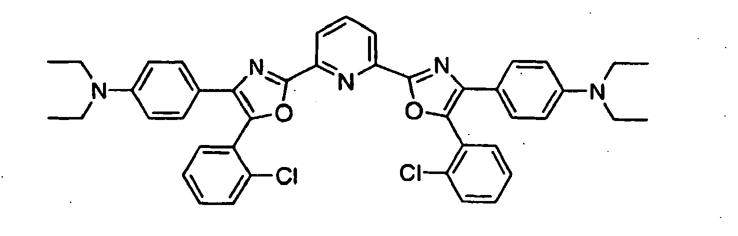

### Sensitizer 14:

### 4-(2-(3,5-bis(5-(2-Chlorophenyl)-4-(4-(diethylamino)phenyl)oxazole-2-yl)phenyl)-5-(2-chlorophenyl)oxazole-4-yl)-N,N-diethylbenzeneamine

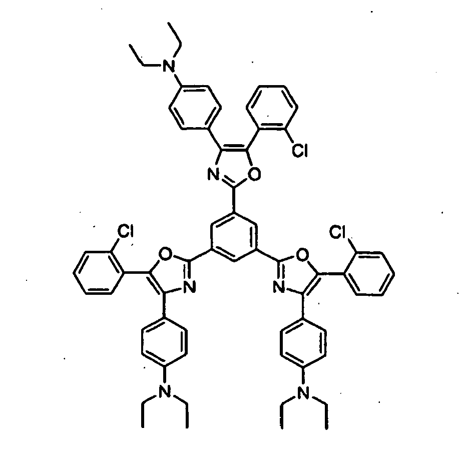

### Sensitizer 15:

### 4-(2-((1E,9E,11E)-3,5-Bis((E)-2-(4-(4-(dimethylamino)phenyl)-5-phenyloxazole-2-yl)vinyl)styryl)-5-phenyloxazole-4-yl)-N,N-dimethylbenzeneamine

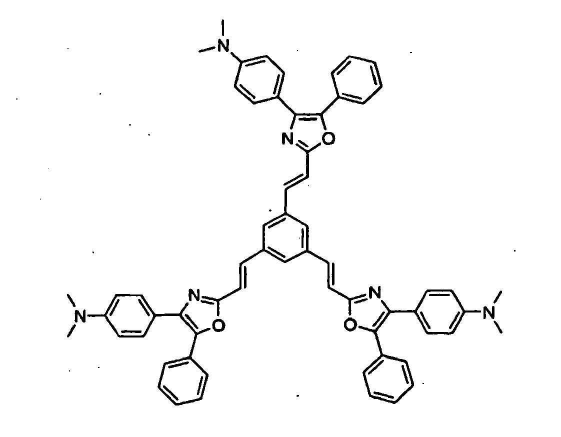

### Sensitizer 16:

### (E)-4-(5-(2-Chlorophenyl)-2-(2-(5-(2-chlorophenyl)-4-(4-(diethylamino)phenyl)oxazole-2-yl)vinyl)oxazole-4-yl)-N,N-diethylbenzeneamine

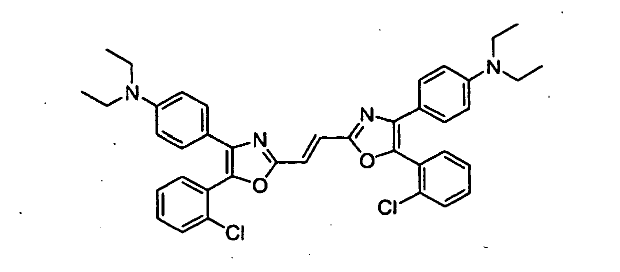

### Sensitizer 17:

### 4-(5-(2-Chlorophenyl)-2-((1E,3E)-4-(5-(2-chlorophenyl)-4-(4-(diethylamino)phenyl)oxazole-2-yl)buta-1,3-dienyl)oxazole-4-yl)-N,N-diethylbenzeneamine

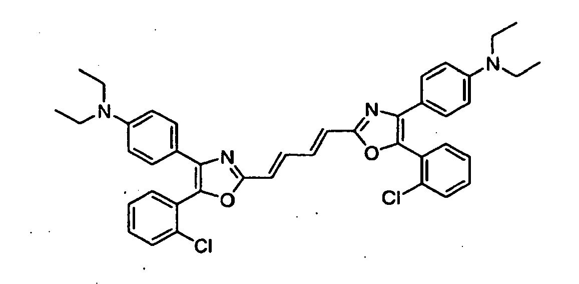

The sensitizers of formula (V) used in the present invention exhibit a strong yellow to greenish fluorescence.

The compounds of formula (V) used in the present invention can be prepared according to processes well known to the person skilled in the art, for example analogously to the process described in EP 0 129 059 and US 3,257,203; the processes described in these documents can also be used for the synthesis of compounds not explicitly described therein by varying the starting compounds accordingly.

The optimum amount of sensitizer depends on various factors such as its extinction coefficient at the emitted wavelength, or the emitted wavelengths of the radiation source used, the thickness of the radiation-sensitive layer of the radiation-sensitive element and its molecular weight. Typically, they are used in amounts of 0.5 to 15 wt.-%, based on the dry layer weight of the radiation-sensitive coating. These values apply to initiator systems of both groups. Each initiator system has an optimum value for the molar ratio (n_{M}= Mol Sens : Mol Coinit) of sensitizer (Sens) and coinitiator (Coinit) which has to be determined by way of appropriate tests. It is usually between 0.1 and 2.

In the present invention, the coinitiators for UV/VIS-sensitive compositions can for example be selected from amines, such as alkanol amines; N,N-dialkylamino benzoic acid esters; N-arylglycines and derivatives thereof (e.g. N-phenylglycine); aromatic sulfonyl halides; trihalomethylsulfones; imides such as N-benzoyloxyphthalimide; diazosulfonates; 9,10-dihydroanthracene derivatives; N-aryl, S-aryl or O-aryl polycarboxylic acids with at least two carboxy groups of which at least one is bonded to the nitrogen, oxygen or sulfur atom of the aryl unit (e.g. aniline diacetic acid and derivatives thereof and other coinitiators described in US-A-5,629,354); hexaarylbiimidazoles such as e.g. 2,2-bis-(2-chlorophenyl)-4,5,4',5'-tetraphenyl-2'H-[1,2']biimidazole and 2,2',5-tris(2-chlorophenyl)-4-(3,4-dimethoxyphenyl)-4,5'-diphenylbi-imidazole; thiol compounds (e.g. 2-mercaptobenzthiazole, 2-mercaptobenzimidazole and 3-mercapto-1,2,4-triazole); phosphines; stannanes; arsines; silanes; 1,3,5-triazine derivatives with 1 to 3 CX₃ groups (wherein every X is independently selected from a chlorine or bromine atom, and is preferably a chlorine atom), such as e.g. 2-phenyl-4,6-bis(trichloromethyl)-s-triazine, 2-(4-methoxyphenyl)-4,6-bis(trichloromethyl)-s-triazine, 2,4,6-tris(trichloromethyl)-s-triazine, 2-methyl-4,6-bis(trichloromethyl)-s-triazine, 2-(styryl-4,6-bis(trichloromethyl)-s-triazine, 2-(p-methoxystyryl)-4,6-bis(trichloromethyl)-s-triazine, 2-(4-methoxy-naphtho-1-yl)-4,6-bis-trichloromethyl-s-triazine, 2-(4-ethoxy-naphtho-1-yl)-4,6-bis(trichloromethyl)-s-triazine and 2-[4-(2-ethoxyethyl)-naphtho-1-yl]-4,6-bis(trichloromethyl)-s-triazine; oxime ethers and oxime esters, such as for example those derived from benzoin; α-hydroxy- or α-amino-acetophenones; alkyltriaryl borates; benzoin ethers and benzoin esters; metallocenes (preferably titanocenes, and especially preferred those with two five-membered cyclodienyl groups, such as e.g. cyclopentadienyl groups and one or two six-membered aromatic groups with at least one ortho fluorine atom and optionally also a pyrryl group, such as bis(cyclopentadienyl)-bis-[2,6-difluoro-3-(pyrr-1-yl)-phenyl]titanium and dicyclopentadiene-bis-2,4,6-trifluorophenyl-titanium or zirconium); onium salts, such as ammonium salts, diaryliodonium salts, triarylsulfonium salts, aryldiazonium salts, phosphonium salts and N-alkoxypyidinium salts; peroxides (e.g. those listed in EP-A1-1 035 435 as activators of the type of an organic peroxide), acylphosphine oxides; azo compounds, diacylphosphine oxides and triacylphosphine oxides.

IR-sensitive elements according to the present invention preferably comprise one or more polyhalogenalkyl-substituted compounds, onium salts and other compounds described in US 6,309,792 B1 as coinitiator.

Polyhalogenalkyl-substituted compounds are compounds comprising either one polyhalogenated or several monohalogenated alkyl substituents. The halogenated alkyl group preferably comprises 1 to 3 carbon atoms; a halogenated methyl group is especially preferred. Fluorine, chlorine and bromine atoms are preferably used as halogen atoms, with chlorine and bromine atoms being especially preferred.

Especially suitable polyhalogenalkyl-substituted compounds and onium salts have already been listed in connection with the coinitiators of the UV- or VIS-sensitive initiator systems.

The absorption properties of the polyhalogenalkyl-substituted compound have a decisive impact on the daylight stability of the IR-sensitive elements. Compounds having a UV/VIS absorption maximum in the range of about 300 to 750 nm lead to elements which can no longer be developed after having been stored in daylight for 6 to 8 minutes and subsequently postheated. In principle, such elements cannot only be imaged with IR light but also with UV light. Thus, if daylight stability of the element is a desired characteristic, polyhalogenalkyl-substituted compounds are preferred that do not show an essential UV/VIS absorption at > 330 nm.

The gist of the present invention is the use of at least one silsesquioxane having at least one substituent with at least one ethylenically unsaturated group each.

"Silsesquioxanes" (also referred to as "silasesquioxanes") are silicon-oxygen compounds of the general formula Si₂ₙH₂ₙO₃ₙ, which formally comprise 1.5 oxygen atoms per silicon atom.

The substituted silsesquioxanes used in the present invention can be described by the general formula (VI)

Si₂ᵤR^{IV}₂ᵤO₃ᵤ (VI)

wherein each R^{IV} is independently selected from H and organic groups, with the proviso that at least one group R^{IV} is an organic group having at least one ethylenically unsaturated group and u assumes values between 8 and 1,000. Products wherein u is 8, 10 or 12 are preferred.

The silsesquioxanes that can be used in the present invention can have a cage structure, a partial cage structure, a ladder structure or a random structure.

The ethylenically unsaturated group can be bonded directly to a Si atom or via a spacer.

Preferably, the at least one organic group R^{IV} with at least one ethylenically unsaturated group is selected from a straight-chain, branched or cyclic alkenyl group preferably comprising 2 to 18 carbon atoms (2 to 10 carbon atoms are especially preferred and 2 to 6 carbon atoms are particularly preferred), a styryl group, an acrylic acid group, a methacrylic acid group, an acrylamide or methacrylamide group, a crotonyl or isocrotonyl group, an itaconic acid group and a maleic acid or fumaric acid group. The groups mentioned above can comprise one or more substituents (preferably 0 or 1 substituent), for example selected from halogen atoms (fluorine, chlorine, bromine, iodine), CN, OR^{V}, SR^{V} or COOR^{V} (R^{V} independently represents a hydrogen atom or an alkyl group).

Suitable spacers are preferably alkylene groups preferably comprising 2 to 6 carbon atoms, alkyleneoxy groups preferably comprising 2 to 6 carbon atoms, alkyl(dialkylsilyloxy) groups (wherein the alkyl groups preferably comprise 1 to 3 carbon atoms) or phenylene groups which can optionally be substituted (preferably 0 or 1 substituent, for example selected from halogen atoms (fluorine, chlorine, bromine, iodine) CN, OR^{V}, SR^{V} or COOR^{V} (R^{V} independently represents a hydrogen atom or an alkyl group)).

Preferably, the silsesquioxane has a molecular weight in the range of 550 to 2,500 g/mole.

The silsesquioxanes used in the present invention are commercially available or can be prepared according to methods known to the person skilled in the art. Such methods are e.g. described in Chem. Rev. 1995, 95,1409-1430.

The silsesquioxanes are preferably present in the radiation-sensitive composition in an amount of 2 to 30 wt.-%, based on the total solids content of the radiation-sensitive layer, an amount of 5 to 15 wt.-% is especially preferred.

According to one embodiment, an IR-sensitive composition of the present invention comprises at least one carboxylic acid of the general formula (VII) as an optional additional component

R²⁸-(CR²⁹R³⁰)ₐ-Y²-CH₂COOH (VII)

wherein:
Y² is selected from O, S or NR³¹, wherein R³¹ represents a hydrogen atom, a C₁-C₆ alkyl group, a group CH₂CH₂COOH or a C₁-C₅ alkyl group substituted with -COOH;
R²⁸, R²⁹ and R³⁰ are each independently selected from a hydrogen atom, C₁-C₆ alkyl group, substituted or unsubstituted aryl group, -COOH or NR³²CH₂COOH, wherein R³² is selected from -CH₂COOH, -CH₂OH and -(CH₂)N(CH₂)COOH; and
a is 0, 1, 2 or 3.

N-aryl-polycarboxylic acids are especially preferred; in particular those of formula (VIIa) below: 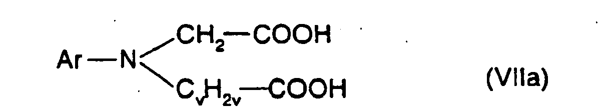 wherein Ar represents a mono- or polysubstituted or unsubstituted aryl group and v is an integer of I to 5,
and of formula (VIIb) 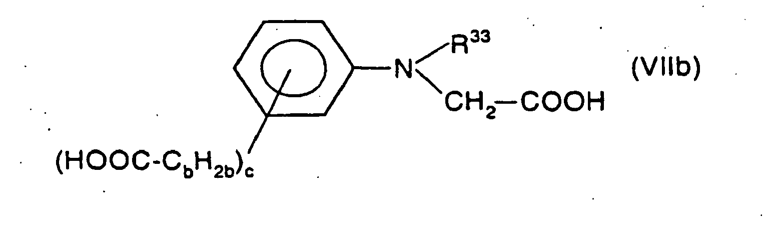 wherein R³³ represents a hydrogen atom or a C₁-C₆ alkyl group and b and c are each an integer from 1 to 5.

Possible substituents of an aryl group are C₁-C₃ alkyl groups, C₁-C₃ alkoxy groups, C₁-C₃ thioalkyl groups and halogen atoms. The aryl group can comprise 1 to 3 identical or different substituents.
v is preferably 1 and Ar preferably represents a phenyl group.

In formula (VIIb) c is preferably 1 and R³³ preferably represents a hydrogen atom.

Examples of such carboxylic acids are :
(p-Acetamidophenylimino)diacetic acid,
3-(bis(carboxymethyl)amino)benzoic acid,
4-(bis(carboxymethyl)amino)benzoic acid,
2-[(carboxymethyl)phenylamino]benzoic acid,
2-[(carboxymethyl)phenylamino]-5-methoxybenzoic acid,
3-[bis(carboxymethyl)amino]-2-naphthalenecarboxylic acid,
N-(4-aminophenyl)-N-(carboxymethyl)glycine,
N,N'-1,3-phenylene-bisglycine,
N,N'-1,3-phenylene-bis[N-(carboxymethyl)]glycine,
N,N'-1,2-phenylene-bis[N-(carboxymethyl)]glycine,
N-(carboxymethyl)-N-(4-methoxyphenyl)glycine,
N-(carboxymethyl)-N-(3-methoxyphenyl)glycine,
N-(carboxymefhyl)-N-(3-hydroxyphenyl)glycine,
N-(carboxymethyl)-N-(3-chlorophenyl)glycine,
N-(carboxymethyl)-N-(4-bromophenyl)glycine,
N-(carboxymethyl)-N-(4-chlorophenyl)glycine,
N-(carboxymethyl)-N-(2-chlorophenyl)glycine,
N-(carboxymethyl)-N-(4-ethylphenyl)glycine,
N-(carboxymethyl)-N-(2,3-dimethylphenyl)glycine,
N-(carboxymethyl)-N-(3,4-dimethylphenyl)glycine,
N-(carboxymethyl)-N-(3,5-dimethylphenyl)glycine,
N-(carboxymethyl)-N-(2,4-dimethylphenyl)glycine,
N-(carboxymethyl)-N-(2,6-dimethylphenyl)glycine,
N-(carboxymethyl)-N-(4-formylphenyl)glycine,
N-(carboxymethyl)-N-ethylanthranilic acid,
N-(carboxymethyl)-N-propylanthranilic acid,
5-bromo-N-(carboxymethyl)anthranilic acid,
N-(2-carboxyphenyl)glycine,
o-dianisidine-N,N,N',N'-tetraacetic acid,
N,N'-[1,2-ethanediyl-bis-(oxy-2,1-phenylene)]bis[N-(carboxymethyl)glycine],
4-carboxyphenoxyacetic acid,
catechol-O,O'-diacetic acid,
4-methylcatechol-O,O'-diacetic acid,
resorcinol-O,O'-diacetic acid,
hydroquinone-O,O'-diacetic acid,
α-carboxy-o-anisic acid,
4,4'-isopropylydenediphenoxyacetic acid,
2,2'-(dibenzofuran-2,8-diyldioxy)diacetic acid,
2-(carboxymethylthio)benzoic acid,
5-amino-2-(carboxymethylthio)benzoic acid,
3-[(carboxymethyl)thio]-2-naphtalenecarboxylic acid.

The most preferred polycarboxylic acid is anilino diacetic acid.

The carboxylic acid is preferably present in the IR-sensitive composition in an amount of from 0 to 10 wt.-%, more preferably 1 to 10 wt.-% and especially preferred 1.5 to 3 wt.-%, based on the total solids content.

Furthermore, the radiation-sensitive composition of the present invention can optionally comprise a binder or binder mixture soluble or swellable in aqueous alkaline developer. Basically all polymers or polymer mixtures known in the technical field of radiation-sensitive compositions can be used as polymeric binders for the radiation-sensitive coating. Linear organic polymers soluble or swellable in water or in aqueous alkaline solutions are especially suitable. Suitable binders are described for example in EP 170 123 A1. Polyvinyl acetals, acrylic acid copolymers, methacrylic acid copolymers, polyurethanes, partially esterified copolymers of maleic acid, novolaks and acidic cellulose derivatives are particularly suitable. It is preferred that the binder comprise acid groups, especially preferred carboxy groups. Acrylic polymers are most preferred. Binders with acid groups preferably have an acid value in the range of 20 to 180 mg KOH/g polymer. Optionally, the binder can comprise groups capable of undergoing a cycloaddition (e.g. photocycloaddition). The amount of binder is not particularly restricted and is preferably in the range of 0 to 90 wt.-%, especially preferred 5 to 60 wt.-%.

The radiation-sensitive composition can also comprise small amounts of a thermopolymerization inhibitor. Suitable examples of inhibitors of an undesired thermopolymerization include e.g. hydroquinone, p-methoxyphenol, di-t-butyl-p-cresol, pyrrogallol, t-butylcatechol, benzoquinone, 4,4'-thio-bis-(3-methyl-6-t-butylphenol), 2,2'-methylene-bis-(4-methyl-6-t-butylphenol) and N-nitrosophenylhydroxylamine salts. The amount of non-absorbable polymerization inhibitor in the radiation-sensitive coating is preferably 0 to 5 wt.-%, based on the dry layer weight, especially preferred 0.01 to 2 wt.-%. Such inhibitors are often introduced into the radiation-sensitive coating via commercial monomers or oligomers and are therefore not expressly mentioned.

Furthermore, the radiation-sensitive composition of the present invention can comprise dyes or pigments for coloring the layer. Examples of colorants include e.g. phthalocyanine pigments, azo pigments, carbon black and titanium dioxide, ethyl violet, crystal violet, azo dyes, anthraquinone dyes and cyanine dyes. The amount of colorant is preferably 0 to 10 wt.-%, based on the dry layer weight, especially preferred 0.5 to 5 wt.-%.

For improving the physical properties of the hardened layer, the radiation-sensitive composition can additionally comprise plasticizers. Suitable plasticizers include e.g. dibutyl phthalate, dioctyl phthalate, didodecyl phthalate, dioctyl adipate, dibutyl sebacate, triacetyl glycerin and tricresyl phosphate. The amount of plasticizer is not particularly restricted, however, it is preferably 0 to 10 wt.-%, based on the dry layer weight, especially preferred 0.25 to 5 wt.-%.

The radiation-sensitive composition can also comprise known chain transfer agents. They are preferably used in an amount of 0 to 15 wt.-%, based on the dry layer weight, especially preferred 0.5 to 5 wt.-%.

Furthermore, the radiation-sensitive composition can comprise leuco dyes such as e.g. leuco crystal violet and leucomalachite green. They are preferably present in an amount of 0 to 10 wt.-%, based on the dry layer weight, especially preferred 0.5 to 5 wt.-%.

Additionally, the radiation-sensitive composition can comprise surfactants. Suitable surfactants include siloxane-containing polymers, fluorine-containing polymers and polymers with ethylene oxide and/or propylene oxide groups. They are preferably present in an amount of 0 to 10 wt.-%, based on the dry layer weight, especially preferred 0.2 to 5 wt.-%.

Exposure indicators, such as e.g. 4-phenylazodiphenylamine, can also be present as optional components of the radiation-sensitive composition; they are preferably present in an amount of 0 to 5 wt.-%, especially preferred 0 to 2 wt.-%, based on the dry layer weight.

The radiation-sensitive elements of the present invention can for example be printing form precursors (in particular precursors of lithographic printing plates), printed circuit boards for integrated circuits or photomasks. The use for the production of printing form precursors is especially preferred.

A dimensionally stable plate or foil-shaped material is preferably used as a substrate in particular in the production of printing form precursors. Preferably, a material is used as dimensionally stable plate or foil-shaped material that has already been used as a substrate for printing matters. Examples of such substrates include paper, paper coated with plastic materials (such as polyethylene, polypropylene, polystyrene), a metal plate or foil, such as e.g. aluminum (including aluminum alloys), zinc and copper plates, plastic films made e.g. from cellulose diacetate, cellulose triacetate, cellulose propionate, cellulose acetate, cellulose acetatebutyrate, cellulose nitrate, polyethylene terephthalate, polyethylene, polystyrene, polypropylene, polycarbonate and polyvinyl acetate, and a laminated material made from paper or a plastic film and one of the above-mentioned metals, or a paper/plastic film that has been metallized by vapor deposition. Among these substrates, an aluminum plate or foil is especially preferred since it shows a remarkable degree of dimensional stability, is inexpensive and furthermore exhibits excellent adhesion to the coating. Furthermore, a composite film can be used wherein an aluminum foil has been laminated onto a polyethylene terephthalate film.

A metal substrate, in particular an aluminum substrate, is preferably subjected to at least one treatment selected from graining (e.g. by brushing in a dry state or brushing with abrasive suspensions, or electrochemical graining, e.g. by means of a hydrochloric acid electrolyte), anodizing (e.g. in sulfuric acid or phosphoric acid) and hydrophilizing.

In order to improve the hydrophilic properties of the surface of the metal substrate that has been grained and optionally anodized in sulfuric acid or phosphoric acid, the metal substrate can be subjected to an aftertreatment with an aqueous solution of sodium silicate, calcium zirconium fluoride, polyvinylphosphonic acid or phosphoric acid. Within the framework of the present invention, the term "substrate" also encompasses an optionally pre-treated substrate exhibiting, for example, a hydrophilizing layer on its surface.

The details of the above-mentioned substrate pre-treatment are known to the person skilled in the art.

For producing a radiation-sensitive element, the radiation-sensitive composition of the present invention is applied to a hydrophilic surface of the substrate by means of common coating processes (e.g. spin coating, dip coating, coating by means of doctor blades). It is also possible to apply the radiation-sensitive composition on both sides of the substrate; however, for the elements of the present invention, it is preferred that the radiation-sensitive coating be only applied to one side of the substrate.

For this purpose, the radiation-sensitive composition comprises one or several organic solvents.

Suitable solvents include low alcohols (e.g. methanol, ethanol, propanol and butanol), glycolether derivatives (e.g. ethylene glycol monomethylether, ethylene glycol dimethylether, propylene glycol monomethylether, ethylene glycol monomethylether acetate, ethylene glycol monoethylether acetate, propylene glycol monomethylether acetate, propylene glycol monoethylether acetate, ethylene glycol monoisopropylether acetate, ethylene glycol monobutylether acetate, diethylene glycol monomethylether, diethylene glycol monoethylether), ketones (e.g. diacetone alcohol, acetyl acetone, acetone, methyl ethyl ketone, cyclohexanone, methyl isobutyl ketone), esters (e.g. methyl lactate, ethyl lactate, acetic acid ethyl ester, 3-methoxypropyl acetate and butyl acetate), aromatics (e.g. toluene and xylene), cyclohexane, γ-butyrolactone, tetrahydrofuran, dimethylsulfoxide, dimethylformamide and N-methylpyrrolidone. The solids content of the radiation-sensitive mixture to be applied depends on the coating method that is used and is preferably 1 to 50 wt.-%.

The additional application of a water-soluble oxygen-impermeable overcoat onto the radiation-sensitive layer can be advantageous. The polymers suitable for such an overcoat include, inter alia, polyvinyl alcohol, polyvinyl alcohol/polyvinyl acetate copolymers, polyvinyl pyrrolidone, polyvinyl pyrrolidone/polyvinyl acetate copolymers, polyvinyl methylethers, ring-opened copolymers of maleic acid anhydride and a comonomer such as methylvinylether, polyacrylic acid, cellulose ether, gelatin, etc.; polyvinyl alcohol is preferred. Preferably, the composition for the oxygen-impermeable overcoat is applied in the form of a solution in water or in a solvent miscible with water; in any case, the solvent is selected such that the radiation-sensitive coating already present on the substrate does not dissolve. The layer weight of the overcoat can e.g. be 0.1 to 6 g/m², preferably 0.5 to 4 g/m². However, the printing plate precursors according to the present invention show excellent properties even without an overcoat. The overcoat can also comprise matting agents (i.e. organic or inorganic particles with a particle size of 2 to 20 µm) which facilitate the planar positioning of the film during contact exposure. In order to improve adhesion of the overcoat to the radiation-sensitive layer, the overcoat can comprise adhesion promoters such as e.g. poly(vinylpyrrolidone), poly(ethyleneimine) and poly(vinylimidazole).

Suitable overcoats are described for example in EP 1 000 387 B1.

The thus produced radiation-sensitive elements are image-wise exposed in a manner known to the person skilled in the art with UV/VIS radiation of a wavelength of >300 nm. For this purpose, common lamps, such as carbon arc lamps, mercury lamps, xenon lamps and metal halide lamps, or lasers or laser diodes can be used. UV laser diodes emitting UV radiation in the range of about 405 nm (e.g. 405 ± 10 nm) and frequency-doubled NdYAG lasers emitting at around 532 nm are of particular interest as a radiation source.

If the sensitizer absorbs IR radiation, i.e. noticeably absorbs radiation of a wavelength in the range of more then 750 to 1,200 nm, and preferably shows an absorption maximum in this range in its absorption spectrum, image-wise exposure can be carried out with IR radiation sources. Suitable radiation sources are semi-conductor lasers or laser diodes which emit in the mentioned wavelength range.

After image-wise exposure, the elements are developed in a manner known to the person skilled in the art, using a commercially available aqueous alkaline developer whereby the exposed areas remain on the substrate and the unexposed areas are removed.

After image-wise exposure, i.e. prior to developing, a heat treatment can be carried out at 50 to 180°C, preferably 90 to 150°C. Sometimes it is advantageous to subject the developed element to a heat treatment (150 to 250°C, preferably 170 to 220°C) or a UV overall exposure or both. The developed elements can be treated with a preservative ("gumming") using a common method. The preservatives are aqueous solutions of hydrophilic polymers, wetting agents and other additives.

The radiation-sensitive elements of the present invention result in printing plates with excellent abrasion resistance, resulting in high print run length.

The invention will be explained in more detail in the following examples; however, they shall not restrict the invention in any way.

### Example 1

A coating solution was prepared from the following components:
- 6.3 g: JONCRYL^{®} 683 (acrylic acid copolymer of the company SC Johnson, USA; acid number = 175 mg KOH/g)
- 9.0 g: AC 50 (methacrylic acid copolymer of the company PCAS, France; acid number = 48 mg KOH/g; 70 wt.-% solution in ethylene glycol monomethyl ether)
- 1.4 g: dipentaerythritol pentaacrylate
- 14.5 g: urethane acrylate (80% solution in methyl ethyl ketone; prepared by reacting Desmodur^{®} N100 of the company Bayer with hydroxyethyl acrylate and pentaerythritol triacrylate; amount of double bonds: 0.5 double bonds per 100 g, when all isocyanate groups have reacted)
- 1.8 g: 2-thio(4-ethenyl)benzyl-5-mercapto-1,3,4-thiadiazole
- 1.8 g: methacryl-POSS cage (mixture of octa, deca and dodeca-γ-(methacryloxy)propyl-substituted silsesquioxane (available from Aldrich))
- 0.45 g: 2-[2-[2-thiophenyl-3-[2-(1,3-dihydro-1,3,3-trimethyl-2H-indole-2-ylidene)-ethylidene]-1-cyclohexene-1-yl]-ethenyl]-1,3,3-trimethyl-3H-indoliumchloride
- 2.5 g: 2-(4-methoxyphenyl)-4,6-bis(trichloromethyl)-1,3,5-triazine and
- 0.4 g: BASONYL VIOLETT 610 (Basic Violett 3, C.I. 42555; available from Bayer, Germany)

The components listed above were dissolved under stirring in 200 ml of a mixture consisting of
90 parts by volume 1-methoxy-2-propanol and
10 parts by volume acetone.
After filtration of the solution, it was applied by means of common processes to an electrochemically grained and anodized aluminum foil that had been subjected to an aftertreatment with an aqueous solution of polyvinylphosphonic acid and the layer was dried for 4 minutes at 90°C. The dry weight of the resulting IR-sensitive layer was about 1.4 g/m².

Then an oxygen-impermeable layer with a dry layer weight of 2.0 g/m² was applied by coating with a solution of the following composition:

| | |
|---|---|
| 42.5 g | Celwol 203 (polyvinyl alcohol of the company Airproducts, USA; 12 wt.-% residual acetyl groups) |
| 7.5 g | polyvinyl imidazole (available from Panchim, France) and |
| 170 g | water |

Drying took place for 5 minutes at 90°C.

The plate precursor produced in this manner was then exposed in a Trendsetter 3244 of the company Creo/Scitex with an 830 nm laser diode (20 W head, 3 W, different drum speeds). An UGRA/FOGRA Postscript 2.0 EPS, which contains different elements for evaluating the quality of the copies, was used for imaging.

The exposed precursor was further processed in a MercuryNews® processor (Kodak Polychrome Graphics LLC) equipped with a preheating section, a pre-wash section, an immersion type developing bath, a section for rinsing with water, a gumming and a drying section. The processor was filled with developer 980 from Kodak Polychrome Graphics LLC. The following parameters were applied for processing the plate precursor: speed 120 cm/min, preheating 630, pre-wash volume 0.5 l/m² plate, temperature of the developing bath 23 ± 1°C. After this treatment, the exposed areas remained on the plate while the unexposed areas were completely removed by the developer.

The following criteria were used for evaluating the copies obtained after preheating and developing: The reproduction quality of 1 pixel elements, the optical density of checkerboard patterns of the pixel elements and the optical density of a solid element. For determining the contrast and the density of solids and dots, a D19/D 196 apparatus (Gretag/Macbeth Color Data Systems, Great Britain) was used.

The results with respect to energy requirements showed that an exposure energy of 31 mJ/cm² was sufficient for a good reproduction of solids, while an energy of 40 mJ/cm² was required for 1 pixel elements. The plate exposed with 40 mJ/cm² was mounted in a sheet-fed offset press and used for printing using an abrasive printing ink (Offset S7184 of Sun Chemical; contains 10% CaCO₃). The image areas accepted the printing ink without any problems and the paper copies did not show any toning in the non-image areas. After 220,000 high-quality copies, printing was discontinued; however, the plate could have been used for more prints. Only very few break-outs were observed in the solids and all fine pixel elements were maintained.

### Example 2

The coating solution of Example 1 was modified by adding 0.45 g anilino diacetic acid and leaving out the 2-thio(4-ethenyl)benzyl-5-mercapto-1,3,4-thiadiazole.

The coating solution and the overcoat solution were applied as described in Example 1. Exposure and developing was carried out as described in Example 1.

The following energy requirements were observed for good prints:
78 mJ/cm² for solids,
107 mJ/cm² for 1 pixel elements.

The plate exposed with 78 mJ/cm² was mounted in a sheet-fed offset press and used for printing using the abrasive printing ink Offset S7184.

The image areas accepted the printing ink without any problems and the paper copies did not show any toning in the non-image areas. After 220,000 high-quality copies, printing was discontinued; however, the plate could have been used for more prints.

Only very few break-outs were observed in the solids and all fine pixel elements were maintained.

### Example 3

An electrochemically grained (in HCl) and anodized aluminum foil was subjected to a treatment with an aqueous solution of polyvinylphosphonic acid (PVPA) and, after drying, coated with the following solution and dried.
- 2.1 g: a 30% solution in 1-methoxy-2-propanol of a terpolymer prepared by polymerization of 470 parts by weight styrene, 336 parts by weight methyl methacrylate and 193 parts by weight methacrylic acid;
- 0.7 g: methacryl-POSS cage (available from Aldrich);
- 6.9 g: of an 80% methyl ethyl ketone solution of a urethane acrylate prepared by reacting Desmodur N 100^{®} (available from Bayer) with hydroxyethyl acrylate and pentaerythritol triacrylate; amount of double bonds: 0.5 double bonds per 100 g when all isocyanate groups have completely reacted with the acrylates containing hydroxy groups;
- 0.8 g: ditrimethylolpropane tetraacrylate;
- 4.4 g: of a dispersion in 1-methoxy-2-propanol comprising 10 wt.-% copper phthalocyanine and 5 wt.-% polyvinylacetal binder comprising 39.9 mole-% vinyl alcohol, 1.2 mole-% vinyl acetate, 15.4 mole-% acetal derived from acetaldehyde, 36.1 mole-% acetal groups derived from butyric aldehyde and 7.4 mole-% acetal groups derived from 4-formylbenzoic acid;
- 1.0 g: 1,4-dihydro-2,6-dimethyl-3,5-di(methoxycarbonyl)-4-phenylpyridine;
- 0.75 g: 2,2-bis-(2-chlorophenyl)-4,5,4',5'-tetraphenyl-2'H-[1,2]biimidazolyl
- 115 ml: 1-methoxy-2-propanol
- 90 ml: methanol
- 130 ml: methyl ethyl ketone

The solution was filtered, applied to the lithographic substrate and the coating was dried for 4 minutes at 90°C. The dry layer weight of the photopolymer layer was about 1.6 g/m².

The resulting plate was provided with an overcoat layer by coating it with the aqueous solution described in Example 1; after drying at 90°C for 4 minutes, the overcoat layer had a dry layer weight of about 2 g/m².

The printing plate precursor was exposed to the light of a Ga-doped MH lamp with an energy of 3.4 mJ/cm² in a vacuum frame using a gray scale having a tonal range of 0.15 to 1.95, wherein the density increments amounted to 0.15 (UGRA gray scale). Immediately after exposure, the plate was heated in an oven for 2 minutes at 90°C.

Then the exposed plate was treated for 30 seconds with developer 952 of Kodak Polychrome Graphics LLC.

Then the developer solution was again rubbed over the surface for another 30 seconds using a tampon and then the entire plate was rinsed with water. After this treatment, the exposed portions remained on the plate. For the assessment of its photosensitivity, the plate was blackened in a wet state with printing ink.

The following results were obtained:
4 solid steps of the gray scale,
step 7 was the first step not to accept ink.

One printing plate precursor was exposed with 3.4 mJ/m² and developed as described above, then the resulting printing plate was mounted in a sheet-fed offset press and used for printing with the abrasive printing ink Offset S7184. After 220,000 copies, no abrasion was observed on the plate.

Only very few break-outs were observed in the solids and all fine pixel elements were maintained.

### Example 4

The coating solution of Example 3 was modified by adding 0.9 g PSS-octa(2(4-cyclohexenyl)ethyldimethylsilyloxy substituted (available from Aldrich) and leaving out the 0.7 g methacryl-POSS cage. A printing plate was produced as described in Example 3.

The following results were obtained:
3 to 4 solid steps,
step 8 was the first step not to accept ink.

One printing plate precursor was exposed with 3.4 mJ/m² and developed as described above. Then the resulting printing plate was mounted in a sheet-fed offset press and used for printing with the abrasive printing ink Offset S7184. After 220,000 copies, no abrasion was observed.

Only very few break-outs were observed in the solids and all fine pixel elements were maintained.

### Comparative Example

Example 1 was repeated, but the coating solution did not contain methacryl-POSS cage. A minimum energy of 33 mJ/cm² was required for a good reproduction of solids, and 41 mJ/cm² for 1 pixel elements.

The printing plate produced by exposure with 41 mJ/cm² was mounted in a sheet-fed offset press and used for printing with the abrasive printing ink Offset S7184. The image areas accepted the printing ink without any problems and the paper copies did not show any toning in the non-image areas.

Printing had to be discontinued after only 150,000 copies because the obtained copies were of poor quality. A high number of break-outs were observed in the solids and the fine elements were affected considerably.

## Claims

1. Radiation-sensitive composition useful for the preparation of a lithographic printing plate precursor, comprising
(i) one or more types of monomers and/or oligomers and/or polymers, each comprising at least one ethylenically unsaturated group accessible to a free-radical polymerization,
(ii) at least one radiation-sensitive initiator or initiator system for free-radical polymerization absorbing radiation selected from the wavelength range of 300 to 1,200 nm; and
**characterized** as further comprising:
(iii) at least one silsesquioxane comprising at least one substituent with at least one ethylenically unsaturated group each.

2. Radiation-sensitive composition according to claim 1, wherein the silsesquioxane is present in the radiation-sensitive composition in an amount of 2 to 30 wt.-%, based on the total solids content.

3. Radiation-sensitive composition according to claim 1 or 2, wherein the initiator system comprises a radiation-absorbing sensitizer and a coinitiator.

4. Radiation-sensitive composition according to claim 1 or 2, wherein component (ii) is a radiation-sensitive initiator which absorbs radiation of a wavelength in the range of 300 to 450 nm.

5. Radiation-sensitive composition according to claim 3, wherein the radiation-absorbing sensitizer absorbs radiation of a wavelength in the range of 300 to 750 nm.

6. Radiation-sensitive composition according to claim 3, wherein the radiation-absorbing sensitizer absorbs radiation of a wavelength in the range of more than 750 to 1,200 nm.

7. Radiation-sensitive composition according to any of claims 1 to 6, wherein the at least one substituent with the at least one ethylenically unsaturated group in the silsesquioxane is selected from a straight-chain, branched or cyclic alkenyl group, a styryl group, an acrylic acid group, a methacrylic acid group, an acrylic acid amide group, a methacrylic acid amide group, a crotonyl group, an isocrotonyl group, an itaconic acid group, a maleic acid group and a fumaric acid group.

8. Radiation-sensitive composition according to any of claims 1 to 7, wherein the ethylenically unsaturated group is bonded directly to a Si atom of the silsesquioxane, or is bonded to a Si atom of the silsesquioxane via a spacer.

9. Radiation-sensitive element comprising
(a) an optionally pretreated substrate and
(b) a radiation-sensitive coating consisting of the composition of any of claims 1 to 8 applied onto the substrate.

10. Process for imaging a radiation-sensitive element comprising
(a) image-wise irradiation of a radiation-sensitive element as defined in claim 9;
(b) removing the non-irradiated areas of the coating by means of an aqueous alkaline developer.

11. Imaged element obtainable according to the process of claim 10.

12. Use of a silsesquioxane comprising at least one substituent with at least one ethylenically unsaturated group each in order to improve the print run stability of lithographic printing forms, produced by radiation-induced free-radical polymerization of negative working printing plate precursors.

## Patentansprüche

1. Strahlungsempfindliche Zusammensetzung geeignet für die Herstellung eines Lithographie-Druckplattenvorläufers, umfassend
(i) ein oder mehrere Arten Monomere und/oder Oligomere und/oder Polymere mit jeweils mindestens einer ethylenisch ungesättigten Gruppe, die einer radikalischen Polymerisation zugänglich ist,
(ii) mindestens einen strahlungsempfindlichen Initiator oder ein Initiatorsystem für radikalische Polymerisation, die Strahlung, ausgewählt aus dem Wellenlängenbereich von 300 bis 1200 nm, absorbieren, und
**dadurch gekennzeichnet, dass** sie weiterhin umfasst:
(iii) mindestens ein Silsesquioxan, welches mindestens einen Substituenten mit jeweils mindestens einer ethylenisch ungesättigten Gruppe aufweist.

2. Strahlungsempfindliche Zusammensetzung gemäß Anspruch 1, wobei das Silsesquioxan in der strahlungsempfindlichen Zusammensetzung in einer Menge von 2 bis 30 Gew.%, bezogen auf den Gesamtfeststoffgehalt, vorhanden ist.

3. Strahlungsempfindliche Zusammensetzung gemäß Anspruch 1 oder 2, wobei das Initiatorsystem einen strahlungsabsorbierenden Sensibilisator und einen Coinitiator umfasst.

4. Strahlungsempfindliche Zusammensetzung gemäß Anspruch 1 oder 2, wobei Komponente (ii) ein strahlungsempfindlicher Initiator ist, der Strahlung einer Wellenlänge im Bereich von 300 bis 450 nm absorbiert.

5. Strahlungsempfindliche Zusammensetzung gemäß Anspruch 3, wobei der strahlungsabsorbierende Sensibilisator Strahlung einer Wellenlänge im Bereich von 300 bis 750 nm absorbiert.

6. Strahlungsempfindliche Zusammensetzung gemäß Anspruch 3, wobei der strahlungsabsorbierende Sensibilisator Strahlung einer Wellenlänge im Bereich von mehr als 750 bis 1200 nm absorbiert.

7. Strahlungsempfindliche Zusammensetzung gemäß einem der Ansprüche 1 bis 6, wobei der mindestens eine Substituent mit der mindestens einen ethylenisch ungesättigten Gruppe im Silsesquioxan aus einer geradkettigen, verzweigten oder cyclischen Alkenylgruppe, einer Styrylgruppe, einer Acrylsäuregruppe, einer Methacrylsäuregruppe, einer Acrylsäureamidgruppe, einer Methacrylsäureamidgruppe, einer Crotonylgruppe, einer Isocrotonylgruppe, einer Itaconsäuregruppe, einer Maleinsäuregruppe und einer Fumarsäuregruppe ausgewählt ist.

8. Strahlungsempfindliche Zusammensetzung gemäß einem der Ansprüche 1 bis 7, wobei die ethylenisch ungesättigte Gruppe direkt an ein Si-Atom des Silsesquioxans gebunden ist oder über einen Spacer an ein Si-Atom des Silsesquioxans gebunden ist.

9. Strahlungsempfindliches Element, umfassend
(a) ein gegebenenfalls vorbehandeltes Substrat und
(b) eine auf das Substrat aufgebrachte strahlungsempfindliche Beschichtung, bestehend aus einer wie in einem der Ansprüche 1 bis 8 definierten Zusammensetzung.

10. Verfahren zum Bebildern eines strahlungsempfindlichen Elements, umfassend
(a) bildweises Bestrahlen eines wie in Anspruch 9 definierten strahlungsempfindlichen Elements;
(b) Entfernen der unbestrahlten Bereiche der Beschichtung mit einem wässrigen alkalischen Entwickler.

11. Bebildertes Element, erhältlich gemäß dem Verfahren von Anspruch 10.

12. Verwendung eines Silsesquioxans, welches mindestens einen Substituenten mit jeweils mindestens einer ethylenisch ungesättigten Gruppe umfasst, zur Erhöhung der Auflagenbeständigkeit von Lithographie-Druckformen, hergestellt durch strahlungsinduzierte radikalische Polymerisation von negativ arbeitenden Druckplattenvorläufem.

## Revendications

1. Composition sensible aux rayonnements utilisable pour préparer un précurseur de plaque d'impression lithographique comprenant :
(i) un ou plusieurs types de monomères et/ou d'oligomères et/ou de polymères, chacun contenant au moins un groupe à insaturation éthylénique accessible à une polymérisation radicalaire,
(ii) au moins un initiateur ou un système initiateur sensible aux rayonnements pour la polymérisation radicalaire absorbant le rayonnement sélectionné dans un intervalle de longueurs d'onde de 300 à 1200 nm ; et
**caractérisé en ce qu'**elle comprend en outre :
(iii) au moins un groupe silsesquioxane contenant au moins un substituant ayant chacun au moins un groupe à insaturation éthylénique.

2. Composition sensible aux rayonnements selon la revendication 1, dans laquelle on utilise une quantité de silsesquioxane dans la composition sensible aux rayonnements de 2 à 30% en poids par rapport à la teneur totale en solides.

3. Composition sensible aux rayonnements selon la revendication 1 ou 2, dans laquelle le système initiateur comprend un sensibilisateur absorbant le rayonnement et un co-initiateur.

4. Composition sensible aux rayonnements selon la revendication 1 ou 2, dans laquelle le composant (ii) est un initiateur sensible aux rayonnements absorbant le rayonnement d'une longueur d'onde de 300 à 450 nm.

5. Composition sensible aux rayonnements selon la revendication 3, dans laquelle le sensibilisateur absorbant le rayonnement absorbe le rayonnement d'une longueur d'onde de 300 à 750 nm.

6. Composition sensible aux rayonnements selon la revendication 3, dans laquelle le sensibilisateur absorbant le rayonnement absorbe le rayonnement d'une longueur d'onde de 750 à 1200 nm.

7. Composition sensible aux rayonnements selon l'une quelconque des revendications 1 à 6, dans laquelle le ou les substituant(s) avec le ou les groupe(s) à insaturation éthylénique dans le groupe silsesquioxane est(sont) sélectionné(s) parmi le groupe englobant le groupe alcényle à chaîne droite, ramifiée ou cyclique, le groupe styryle, le groupe acide acrylique, le groupe acide méthacrylique, le groupe amide acide acrylique, le groupe amide acide méthacrylique, le groupe crotonyle, le groupe isocrotonyle, le groupe acide itaconique, le groupe acide maléique et le groupe acide fumarique.

8. Composition sensible aux rayonnements selon l'une quelconque des revendications 1 à 7, dans laquelle le groupe à insaturation éthylénique est relié directement à un atome Si du groupe silsesquioxane ou est relié à un atome Si du groupe silsesquioxane par l'intermédiaire d'un espaceur.

9. Elément sensible aux rayonnements comprenant
(a) un substrat éventuellement pré-traité, et
(b) une couche sensible aux rayonnements consistant à la composition selon l'une quelconque des revendications 1 à 8 appliquée sur le substrat.

10. Procédé de formation d'une image sur un élément sensible aux rayonnements comprenant :
(a) irradier, conformément à l'image, un élément sensible aux rayonnements tel que défini dans la revendication 9 ;
(b) éliminer les zones non irradiées de la couche au moyen d'un révélateur alcalin aqueux.

11. Elément imagé pouvant être obtenu selon le procédé de la revendication 10.

12. Utilisation d'un groupe silsesquioxane comprenant au moins un substituant ayant chacun au moins un groupe à insaturation éthylénique, afin d'améliorer la stabilité du cycle d'impression des clichés d'impression lithographiques produits par polymérisation radicalaire induite par un rayonnement de précurseurs de plaques d'impression de type négatif.
